# EUROPÄISCHE PATENTSCHRIFT

(11) **EP 2 297 275 B1**
(45) Veröffentlichungstag und Bekanntmachung des Hinweises auf die Patenterteilung: **23.11.2011**
(21) Anmeldenummer: 09776556.4
(22) Anmeldetag: 22.04.2009
(51) Int. Cl.: C09K 11/06

(54) **ORGANISCHE ELEKTROLUMINESZENZVORRICHTUNG**
ORGANIC ELECTROLUMINESCENCE DEVICE
DISPOSITIF ÉLECTROLUMINESCENT ORGANIQUE

(30) Priorität: 17.07.2008 DE 102008033563
(43) Veröffentlichungstag der Anmeldung: 23.03.2011
(73) Patentinhaber: Merck Patent GmbH, 64293 Darmstadt (DE)
(72) Erfinder: STOESSEL, Philipp, 60487 Frankfurt am Main (DE); JOOSTEN, Dominik, 60487 Frankfurt am Main (DE); BREUNING, Esther, 64372 Ober-Ramstadt (DE); YERSIN, Hartmut, 93161 Sinzing (DE); MONKOWIUS, Uwe, A-4020 Linz (AT)
(86) Internationale Anmeldenummer: PCT/EP2009/002941
(87) Internationale Veröffentlichungsnummer: WO 2010/006666

(56) Entgegenhaltungen:
- EP-A- 1 930 392
- WO-A-2005/056712
- WO-A-2005/117161
- WO-A-2005/118606
- WO-A-2006/098120
- WO-A-2007/031185
- DE-A1-102006 017 485
- DE-A1-102007 031 261
- US-A1- 2002 048 689
- US-A1- 2005 214 576
- BAO-HUI XIA: "Metal-Metal Interactions in Dinuclear d8 Metal Cyanide Complexes" INORGANIC CHEMISTRY, Bd. 41, 2002, Seiten 3866-3875, XP002541561 USA in der Anmeldung erwähnt
- D.R. STRIPLIN: "Excited States of Homo- and Heteronuclear-Bridged Bimetallic Complexes" JOURNAL OF PHYSICAL CHEMISTRY, Bd. 99, 1995, Seiten 7977-7984, XP002541560 USA in der Anmeldung erwähnt
- W. PETZ: "Reaction of the Carbodiphosphorane Ph3P=C=PPh3 with Platinum(II) and -(0) Compounds" ORGANOMETALLICS, Bd. 24, 2005, Seiten 5038-5043, XP002541562 USA in der Anmeldung erwähnt

## Beschreibung

Die vorliegende Anmeldung betrifft organische Elektrolumineszenzvorrichtungen, welche lumineszierende Metallkomplexe enthalten, sowie lumineszierende Metallkomplexe.

Der Aufbau organischer Elektrolumineszenzvorrichtungen (OLEDs), in denen organische Halbleiter als funktionelle Materialien eingesetzt werden, ist beispielsweise in US 4539507, US 5151629, EP 0676461 und WO 98/27136 beschrieben. Dabei werden als emittierende Materialien zunehmend metallorganische Komplexe eingesetzt, die Phosphoreszenz statt Fluoreszenz zeigen (M. A. Baldo et al., Appl. Phys. Lett. 1999, 75, 4-6). Aus quantenmechanischen Gründen ist unter Verwendung metallorganischer Verbindungen als Phosphoreszenzemitter eine bis zu vierfache Energie- und Leistungseffizienz möglich. Gemäß dem Stand der Technik werden in phosphoreszierenden OLEDs als Triplettemitter meist einkernige Iridium- oder Platinkomplexe eingesetzt. Bei diesen Verbindungen gibt es noch weiteren Verbesserungsbedarf, insbesondere hinsichtlich der Lebensdauer, der Effizienz, der Betriebsspannung und der Stabilität der Komplexe, um diese in langlebigen Elektrolumineszenzvorrichtungen, beispielsweise für Fernseher oder Computermonitore, einsetzen zu können.

Aufgabe der vorliegenden Erfindung ist daher die Bereitstellung neuer organischer Elektrolumineszenzvorrichtungen enthaltend Metallkomplexe. Dabei werden die Metallkomplexe insbesondere als Emitter in einer Emissionsschicht eingesetzt. Insbesondere besteht Verbesserungsbedarf noch bei grün und blau phosphoreszierenden Metallkomplexen.

Aus der Patentanmeldung DE 10 2006 017485 A1 (UNIV REGENSBURG [DE], 18. Oktober 2007 (2007-10-18)) sind organische Elektrolumineszenzvorrichtung bekannt, die Komplexe der Formel (s-bph)ML enthalten (siehe Ansprüche 1, 8, 10; Tabelle 1 für M = Pt; L,L' = dppm; Komplex 3).

Überraschend wurde gefunden, dass bestimmte organische Elektrolumineszenzvorrichtungen enthaltend die unten näher beschriebenen dimeren Metallkomplexe diese Aufgabe lösen. Diese Metallkomplexe eignen sich sehr gut für die Verwendung als Emitter in einer Emissionsschicht und führen zu Verbesserungen der organischen Elektrolumineszenzvorrichtung, insbesondere hinsichtlich der Lebensdauer und der Effizienz. Dies gilt insbesondere für grün und blau phosphoreszierende Elektrolumineszenzvorrichtungen. Organische Elektrolumineszenzvorrichtungen, welche diese Komplexe enthalten, sind daher der Gegenstand der vorliegenden Erfindung. Ein weiterer Gegenstand der vorliegenden Erfindung sind Metallkomplexe, die in organischen Elektrolumineszenzvorrichtungen Anwendung finden können.

Aus dem Stand der Technik sind dimere Metallkomplexe bekannt. Che et al. (Inorg. Chem. 2002, 41, 3866-3875) offenbaren zweikernige Platin- und Nickelkomplexe, bei denen die Metallatome durch P-C-P-Liganden überbrückt werden. Es findet sich jedoch kein Hinweis, dass sich derartige Metallkomplexe für die Verwendung in organischen Elektrolumineszenzvorrichtungen eignen.

Weitere derartige Komplexe werden von D. R. Striplin et al. (J. Phys. Chem. 1995, 99, 7977-7984) beschrieben, die allgemeine physikalische Eigenschaften dieser Komplexe untersuchen. Es findet sich jedoch kein Hinweis, dass sich derartige Metallkomplexe für die Verwendung in organischen Elektrolumineszenzvorrichtungen eignen.

Gegenstand der Erfindung ist somit eine organische Elektrolumineszenzvorrichtung, enthaltend mindestens eine Verbindung der folgenden Formel (1), 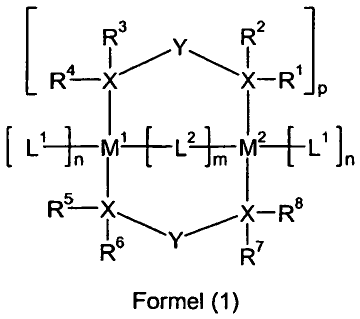 wobei für die verwendeten Symbole und Indizes gilt:
- M¹, M²: ist bei jedem Auftreten gleich oder verschieden ein Metall ausgewählt aus der Gruppe bestehend aus Pt, Pd, Ni, Ir, Rh, Mo, W, Re, Ru oder Os;
- X: ist bei jedem Auftreten gleich oder verschieden P, As, Sb oder Bi;
- Y: ist bei jedem Auftreten gleich oder verschieden C(R⁹)₂, Si(R⁹)₂, B(R⁹), N(R⁹), P(R⁹), O, S, Se, C(=O), C(=S), C(=NR⁹) oder C(=C(R⁹)₂);
- L¹: ist bei jedem Auftreten gleich oder verschieden ein monodentater Ligand oder ein bidentater Ligand, der an eines der Metallatome M¹ bzw. M² koordiniert; dabei kann L¹ auch mit einer der Gruppen R¹ bis R⁸ verknüpft sein;
- L²: ist bei jedem Auftreten gleich oder verschieden ein bidentater Ligand, der gleichzeitig an beide Metallatome M¹ und M² koordiniert;
- R¹ bis R⁸: ist bei jedem Auftreten gleich oder verschieden F, Cl, Br, I, N(R¹⁰)₂, CN, Si(R¹⁰)₃, C(=O)R¹⁰, P(R¹⁰)₂, eine geradkettige Alkyl-, Alkoxy- oder Thioalkoxygruppe mit 1 bis 40 C-Atomen oder eine geradkettige Alkenyl- oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die jeweils mit einem oder mehreren Resten R¹⁰ substituiert sein kann, wobei eine oder mehrere nicht benachbarte CH₂-Gruppen, die nicht direkt an X binden, durch R¹⁰C=CR¹⁰, C≡C, Si(R¹⁰)₂, Ge(R¹⁰)₂, Sn(R¹⁰)₂, C=O, C=S, C=Se, C=NR¹⁰, P(=O)(R¹⁰), SO, SO₂, NR¹⁰, O, S oder CONR¹⁰ ersetzt sein können und wobei ein oder mehrere H-Atome durch D, F, Cl, Br, I, CN oder NO₂ ersetzt sein können, oder ein aromatisches oder heteroaromatisches Ringsystem mit 5 bis 60 aromatischen Ringatomen, das jeweils durch einen oder mehrere Reste R¹⁰ substituiert sein kann, oder eine Aralkyl- oder Heteroaralkylgruppe mit 5 bis 40 aromatischen Ringatomen, die jeweils durch einen oder mehrere Reste R¹⁰ substituiert sein kann, oder eine Aryloxy- oder Heteroaryloxygruppe mit 5 bis 40 aromatischen Ringatomen, die durch einen oder mehrere Reste R¹⁰ substituiert sein kann, oder eine Diaryl- aminogruppe, Diheteroarylaminogruppe oder Arylheteroarylaminogruppe mit 10 bis 40 aromatischen Ringatomen, welche durch einen oder mehrere Reste R¹⁰ substituiert sein kann; dabei können R¹ und R² R³ und R⁴, R⁵ und R⁶ und/oder R⁷ und R⁸ auch miteinander ein mono- oder polycyclisches, aliphatisches, aromatisches und/oder benzoannelliertes Ringsystem bilden; außerdem können ein oder mehrere Reste R¹ bis R⁸ mit einem oder mehreren Liganden L¹ oder L² verknüpft sein und so einen polydentaten Liganden bilden;
- R⁹: ist bei jedem Auftreten gleich oder verschieden H, D, F, Cl, Br, I, N(R¹⁰)₂, CN, NO₂, Si(R¹⁰)₃, B(OR¹⁰)₂, C(=O)R¹⁰, P(=O)(R¹⁰)₂, S(=O)R¹⁰, S(=O)₂R¹⁰, OSO₂R¹⁰, eine geradkettige Alkyl-, Alkoxy- oder Thioalkoxygruppe mit 1 bis 40 C-Atomen oder eine geradkettige Alkenyl- oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die jeweils mit einem oder mehreren Resten R¹⁰ substituiert sein kann, wobei eine oder mehrere nicht benachbarte CH₂-Gruppen durch R¹⁰C=CR¹⁰, C=C, Si(R¹⁰)₂, Ge(R¹⁰)₂, Sn(R¹⁰)₂, C=O, C=S, C=Se, C=NR¹⁰, P(=O)(R¹⁰), SO, SO₂, NR¹⁰, O, S oder CONR¹⁰ ersetzt sein können und wobei ein oder mehrere H-Atome durch D, F, Cl, Br, I, CN oder NO₂ ersetzt sein können, oder ein aromatisches oder heteroaromatisches Ringsystem mit 5 bis 60 aromatischen Ringatomen, das jeweils durch einen oder mehrere Reste R¹⁰ substituiert sein kann, oder eine Aralkyl- oder Heteroaralkylgruppe mit 5 bis 40 aromatischen Ringatomen, die jeweils durch einen oder mehrere Reste R¹⁰ substituiert sein kann, oder eine Aryloxy- oder Heteroaryloxygruppe mit 5 bis 40 aromatischen Ringatomen, die durch einen oder mehrere Reste R¹⁰ substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste R¹⁰ substituiert sein Kann; dabei können auch zwei Reste R⁹, welche an dasselbe C- oder Si-Atom gebunden sind, miteinander ein mono- oder polycyclisches, aliphatisches, aromatisches und/oder benzoannelliertes Ringsystem bilden;
- R¹⁰: ist bei jedem Auftreten gleich oder verschieden H, D, F, Cl, Br, I, N(R¹¹)₂, CN, NO₂, Si(R¹¹)₃, B(OR¹¹)₂, C(=O)R¹¹, P(=O)(R¹¹)₂, S(=O)R¹¹, S(=O)₂R¹¹, OSO₂R¹¹, eine geradkettige Alkyl-, Alkoxy- oder Thioalkoxygruppe mit 1 bis 20 C-Atomen oder eine geradkettige Alkenyl- oder Alkinylgruppe mit 2 bis 20 C-Atomen oder eine verzweigte oder cyclische Alkyl-, Alkenyl-, Alkinyl-, Alkoxy- oder Thioalkoxygruppe mit 3 bis 20 C-Atomen, die jeweils mit einem oder mehreren Resten R¹¹ substituiert sein kann, wobei eine oder mehrere nicht benachbarte CH₂-Gruppen durch R¹¹C=CR¹¹, C≡C, Si(R¹¹)₂, Ge(R¹¹)₂, Sn(R¹¹)₂, C=O, C=S, C=Se, C=NR¹¹, P(=O)(R¹¹), SO, SO₂, NR¹¹, O, S oder CONR¹¹ ersetzt sein können und wobei ein oder mehrere H-Atome durch D, F, Cl, Br, I, CN oder NO₂ ersetzt sein können, oder ein aromatisches oder heteroaromatisches Ringsystem mit 5 bis 60 aromatischen Ringatomen, das jeweils durch einen oder mehrere Reste R¹¹ substituiert sein kann, oder eine Aryloxy- oder Heteroaryloxygruppe mit 5 bis 40 aromatischen Ringatomen, die durch einen oder mehrere Reste R¹¹ substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste R¹¹ substituiert sein kann; dabei können zwei oder mehrere benachbarte Reste R¹¹ miteinander ein mono- oder polycyclisches, aliphatisches oder aromatisches Ringsystem bilden;
- R¹¹: ist bei jedem Auftreten gleich oder verschieden H, D, F oder ein aliphatischer, aromatischer und/oder heteroaromatischer Kohlenwasserstoffrest mit 1 bis 20 C-Atomen, in dem auch ein oder mehrere H-Atome durch F ersetzt sein können; dabei können zwei oder mehrere Substituenten R¹¹ auch miteinander ein mono- oder polycyclisches, aliphatisches oder aromatisches Ringsystem bilden;
- m, n: sind bei jedem Auftreten gleich oder verschieden 0, 1, 2 oder 3;
- p: ist 0, 1, 2 oder 3;
mit der Maßgabe, dass die Indizes m, n und p so gewählt sind, dass die Koordinationszahl an jedem der Metalle M¹ und M² vier oder fünf ergibt.

Dem Fachmann der metallorganischen Chemie ist bekannt, welche Metalle üblicherweise welche Koordinationszahlen aufweisen. Unter der Koordinationszahl wird die Anzahl der an das Metall koordinierenden Atome verstanden. Dies sind zum einen die koordinierenden Atome X und zum anderen die koordinierenden Atome der Liganden L¹ und L². Dabei beträgt die übliche Koordinationszahl um Pt(II), Pd(II), Ni(II), Ir(I) und Rh(I) vier, kann jedoch auch fünf betragen. Weiterhin beträgt die übliche Koordinationszahl um Mo(0), W(0), Re(I), Ru(II) und Os(II) fünf. In einer bevorzugten Ausführungsform der Erfindung werden m, n und p daher so gewählt, dass die Koordinationszahl um Pt, Pd, Ni, Ir und Rh vier beträgt und dass die Koordinationszahl um Mo, W, Re, Ru und Os fünf beträgt.

Dabei koordiniert der Ligand L² immer über ein Atom an das Metallatom M¹ und über ein Atom an das Metallatom M², wobei es sich bei den koordinierenden Atomen des Liganden L² um dasselbe Atom handeln kann, das gleichzeitig an M¹ und M² koordiniert, oder um unterschiedliche Atome. Wenn der Ligand L¹ ein monodentater Ligand ist, koordiniert er über ein Atom an das Metall M¹ oder M². Wenn der Ligand L¹ ein bidentater Ligand ist, koordiniert er über zwei Atome an eines der Metalle M¹ oder M²_{.}

Geeignete Kombinationen der Liganden L¹ und L², um die Koordinationszahl vier zu erreichen, sind beispielsweise:
p=0, n = 0 und m = 3; oder
p = 0, n = 1 mit L¹ = monodentater Ligand und m = 2; oder
p = 0, n = 2 mit L¹ = monodentater Ligand und m = 1; oder
p = 0, n = 1 mit L¹ = bidentater Ligand und m = 1; oder
p = 0, n = 3 mit L¹ = monodentater Ligand und m = 0; oder
p = 0, n = 2 mit L¹ = monodentater + bidentater Ligand und m = 0; oder
p = 1, n = 0 und m = 2; oder
p = 1, n = 1 mit L¹ = monodentater Ligand und m = 1; oder
p = 1, n = 2 mit L¹ = monodentater Ligand und m = 0; oder
p = 1, n = 1 mit L¹ = bidentater Ligand und m = 0; oder
p = 2, n = 1 mit L¹ = monodentater Ligand und m = 0; oder
p = 2, n = 0 und m = 1; oder
p = 3, n = 0 und m = 0.

Geeignete Kombinationen der Liganden L¹ und L², um die Koordinationszahl fünf zu erreichen sind beispielsweise:
p = 0, n = 1 mit L¹ = monodentater Ligand und m = 3; oder
p = 0, n = 2 mit L¹ = monodentater Ligand und m = 2; oder
p = 0, n = 1 mit L¹ = bidentater Ligand und m = 3; oder
p = 0, n = 3 mit L¹ = monodentater Ligand und m = 3; oder
p = 0, n = 2 mit L¹ = monodentater + bidentater Ligand und m = 2; oder
p = 0, n = 4 mit L¹ = bidentater Ligand und m = 0; oder
p = 0, n = 2 mit L¹ = bidentater Ligand und m = 0; oder
p = 1, n = 1 mit L¹ = monodentater Ligand und m = 2; oder
p = 1, n = 2 mit L¹ = monodentater Ligand und m = 1; oder
p = 1, n = 1 mit L¹ = bidentater Ligand und m = 1; oder
p = 1, n = 3 mit L¹ = monodentater Ligand und m = 0; oder
p = 1, n = 2 mit L¹ = monodentater + bidentater Ligand und m = 0; oder
p = 2, n = 1 mit L¹ = monodentater Ligand und m = 1; oder
p = 2, n = 2 mit L¹ = monodentater Ligand und m = 0; oder
p = 2, n =0 und m =2.

Wenn der Index p = 1 ist, können die Liganden R₂X-Y-XR₂ im Komplex cis-ständig oder trans-ständig angeordnet sein, wie im Folgenden schematisch dargestellt für Komplexe, die jeweils noch vier weitere monodentate Liganden L¹ enthalten, wobei die Liganden R₂X-Y-XR₂ jeweils durch X∩X dargestellt sind:

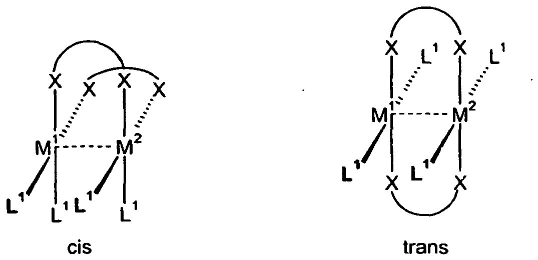

Wenn die Liganden L¹ oder wenigstens einer der Liganden L¹ für bidentate Liganden stehen, müssen die Liganden R₂X-Y-XR₂ cis-ständig angeordnet sein. Wenn die Liganden L¹ monodentate Liganden sind, so handelt es sich bevorzugt um Komplexe mit trans-ständigen Liganden.

Unter einer organischen Elektrolumineszenzvorrichtung im Sinne dieser Erfindung wird eine Elektrolumineszenzvorrichtung verstanden, welche Anode, Kathode und mindestens eine emittierende Schicht enthält, wobei mindestens eine Schicht, welche zwischen Anode und Kathode angeordnet ist, mindestens eine organische oder metallorganische Verbindung bzw. mindestens eine Metallkoordinationsverbindung enthält. Die erfindungsgemäße organische Elektrolumineszenzvorrichtung enthält also Anode, Kathode und mindestens eine emittierende Schicht, wobei mindestens eine Schicht mindestens eine Verbindung der oben aufgeführten Formel (1) enthält.

Weiterhin finden in der vorliegenden Anmeldung die folgenden Definitionen Anwendung:

Eine Arylgruppe im Sinne dieser Erfindung enthält 6 bis 40 C-Atome; eine Heteroarylgruppe im Sinne dieser Erfindung enthält 2 bis 39 C-Atome und mindestens ein Heteroatom, mit der Maßgabe, dass die Summe aus C-Atomen und Heteroatomen mindestens 5 und höchstens 40 ergibt. Die Heteroatome sind bevorzugt ausgewählt aus N, O und/oder S. Dabei wird unter einer Arylgruppe bzw. Heteroarylgruppe entweder ein einfacher aromatischer Cyclus, also Benzol, bzw. ein einfacher heteroaromatischer Cyclus, beispielsweise Pyridin, Pyrimidin, Thiophen, etc., oder eine kondensierte Aryl- oder Heteroarylgruppe, beispielsweise Naphthalin, Anthracen, Phenanthren, Chinolin, Isochinolin, etc., verstanden. Ein cyclisches Carben im Sinne dieser Erfindung ist eine cyclische Gruppe, welche über ein neutrales C-Atom an das Metall bindet. Dabei kann die cyclische Gruppe gesättigt oder ungesättigt sein. Bevorzugt sind hierbei Arduengo-Carbene, also solche Carben, bei welchen an das Carben-C-Atom zwei Stickstoffatome gebunden sind. Dabei wird ein Fünfring-Arduengo-Carben bzw. ein anderes ungesättigtes Fünfring-Carben ebenfalls als eine Arylgruppe im Sinne dieser Erfindung angesehen. Unter einer Aralkylgruppe im Sinne der vorliegenden Erfindung werden Alkylgruppen verstanden, insbesondere die unten aufgeführten Alkylgruppen, welche mit einer Aryl- oder Heteroarylgruppe, insbesondere einer der unten aufgeführten Aryl- oder Heteroarylgruppen, substituiert sind.

Ein aromatisches Ringsystem im Sinne dieser Erfindung enthält 6 bis 60 C-Atome im Ringsystem. Ein heteroaromatisches Ringsystem im Sinne dieser Erfindung enthält 2 bis 59 C-Atome und mindestens ein Heteroatom im Ringsystem, mit der Maßgabe, dass die Summe aus C-Atomen und Heteroatomen mindestens 5 und höchstens 60 ergibt. Die Heteroatome sind bevorzugt ausgewählt aus N, O und/oder S. Unter einem aromatischen oder heteroaromatischen Ringsystem im Sinne dieser Erfindung soll ein System verstanden werden, das nicht notwendigerweise nur Aryl-oder Heteroarylgruppen enthält, sondern in dem auch mehrere Aryl- oder Heteroarylgruppen durch eine nicht-aromatische Einheit, wie z. B. ein sp³-hybridisiertes C-, N- oder O-Atom, unterbrochen sein können. So sollen beispielsweise auch Systeme wie 9,9'-Spirobifluoren, 9,9-Diarylfluoren, Triarylamin, Diarylether, Stilben, etc. als aromatische Ringsysteme im Sinne dieser Erfindung verstanden werden, und ebenso Systeme, in denen zwei oder mehrere Arylgruppen beispielsweise durch eine lineare oder cyclische Alkylgruppe oder durch eine Silylgruppe unterbrochen sind.

Im Rahmen der vorliegenden Erfindung werden unter einer C₁- bis C₄₀-Alkylgruppe bzw. C₁- bis C₂₀-Alkylgruppe, in der auch einzelne H-Atome oder CH₂-Gruppen durch die oben genannten Gruppen substituiert sein können, beispielsweise die Reste Methyl, Ethyl, n-Propyl, i-Propyl, n-Butyl, i-Butyl, s-Butyl, t-Butyl, 2-Methylbutyl, n-Pentyl, s-Pentyl, t-Pentyl, 2-Pentyl, Cyclopentyl, n-Hexyl, s-Hexyl, t-Hexyl, 2-Hexyl, 3-Hexyl, Cyclohexyl, 2-Methylpentyl, n-Heptyl, 2-Heptyl, 3-Heptyl, 4-Heptyl, Cycloheptyl, 1-Methylcyclohexyl, n-Octyl, 2-Ethylhexyl, Cyclooctyl, 1-Bicyclo[2,2,2]octyl, 2-Bicyclo[2,2,2]octyl, 2-(2,6-Dimethyl)octyl, 3-(3,7-Dimethyl)octyl, Trifluormethyl, Pentafluorethyl oder 2,2,2-Trifluorethyl verstanden. Unter einer Alkenylgruppe werden beispielsweise Ethenyl, Propenyl, Butenyl, Pentenyl, Cyclopentenyl, Hexenyl, Cyclohexenyl, Heptenyl, Cycloheptenyl, Heptenyl, Cycloheptenyl, Octenyl oder Cyclooctenyl verstanden. Unter einer Alkinylgruppe werden beispielsweise Ethinyl, Propinyl, Butinyl, Pentinyl, Hexinyl, Heptinyl oder Octinyl verstanden. Unter einer C₁- bis C₄₀-Alkoxygruppe werden beispielsweise Methoxy, Trifluormethoxy, Ethoxy, n-Propoxy, i-Propoxy, n-Butoxy, i-Butoxy, s-Butoxy, t-Butoxy oder 2-Methylbutoxy verstanden. Unter einem aromatischen oder heteroaromatischen Ringsystem mit 5 - 60 aromatischen Ringatomen, welches noch jeweils mit den oben genannten Resten R substituiert sein kann und welches über beliebige Positionen am Aromaten bzw. Heteroaromaten verknüpft sein kann, werden beispielsweise Gruppen verstanden, die abgeleitet sind von Benzol, Naphthalin, Anthracen, Phenanthren, Benzanthracen, Pyren, Chrysen, Perylen, Fluoranthen, Naphthacen, Pentacen, Benzpyren, Biphenyl, Biphenylen, Terphenyl, Terphenylen, Fluoren, Spirobifluoren, Dihydrophenanthren, Dihydropyren, Tetrahydropyren, cis- oder trans-Indenofluoren, Truxen, Isotruxen, Spirotruxen, Spiroisotruxen, Furan, Benzofuran, Isobenzofuran, Dibenzofuran, Thiophen, Benzothiophen, Isobenzothiophen, Dibenzothiophen, Pyrrol, Indol, Isoindol, Carbazol, Pyridin, Chinolin, Isochinolin, Acridin, Phenanthridin, Benzo-5,6-chinolin, Benzo-6,7-chinolin, Benzo-7,8-chinolin, Phenothiazin, Phenoxazin, Pyrazol, Indazol, Imidazol, Benzimidazol, Naphthimidazol, Phenanthrimidazol, Pyridimidazol, Pyrazinimidazol, Chinoxalinimidazol, Oxazol, Benzoxazol, Naphthoxazol, Anthroxazol, Phenanthroxazol, Isoxazol, 1,2-Thiazol, 1,3-Thiazol, Benzothiazol, Pyridazin, Benzopyridazin, Pyrimidin, Benzpyrimidin, Chinoxalin, 1,5-Diazaanthracen, 2,7-Diazapyren, 2,3-Diazapyren, 1,6-Diazapyren, 1,8-Diazapyren, 4,5-Diazapyren, 4,5,9,10-Tetraazaperylen, Pyrazin, Phenazin, Phenoxazin, Phenothiazin, Fluorubin, Naphthyridin, Azacarbazol, Benzocarbolin, Phenanthrolin, 1,2,3-Triazol, 1,2,4-Triazol, Benzotriazol, 1,2,3-Oxadiazol, 1,2,4-Oxadiazol, 1,2,5-Oxadiazol, 1,3,4-Oxadiazol, 1,2,3-Thiadiazol, 1,2,4-Thiadiazol, 1,2,5-Thiadiazol, 1,3,4-Thiadiazol, 1,3,5-Triazin, 1,2,4-Triazin, 1,2,3-Triazin, Tetrazol, 1,2,4,5-Tetrazin, 1,2,3,4-Tetrazin, 1,2,3,5-Tetrazin, Purin, Pteridin, Indolizin und Benzothiadiazol.

Im Folgenden werden die Ausführungsformen der Verbindung gemäß Formel (1) beschrieben, wie sie bevorzugt in der organischen Elektrolumineszenzvorrichtung verwendet wird.

Die Verbindungen der Formel (1) können geladen oder ungeladen sein. In einer bevorzugten Ausführungsform der Erfindung sind die Verbindungen der Formel (1) ungeladen, d. h. elektrisch neutral. Dies wird auf einfache Weise dadurch erreicht, dass die Liganden L¹ und L² so gewählt werden, dass sie die Ladungen der Metallatome M¹ und M² kompensieren.

Wenn die Verbindungen der Formel (1) geladen sind, enthalten sie noch ein oder mehrere Gegenionen. Beispiele für positiv geladene Gegenionen, wenn die Verbindung der Formel (1) negativ geladen ist, sind Alkalimetallionen, Erdalkalimetallionen, Tetraalkylammoniumionen oder Tetraalkylphosphoniumionen, wobei die Alkylgruppe jeweils bevorzugt 1 bis 4 C-Atome enthält. Beispiele für negativ geladene Gegenionen, wenn die Verbindung der Formel (1) positiv geladen ist, sind F, Cl, Br, I, Cyanid, Hexafluorophosphat, Tetrafluoroborat, Tetraphenylborat, Sulfat, Phosphat oder Oxalat.

Die Metalle M¹ und M² in Verbindungen der Formel (1) sind bevorzugt bei jedem Auftreten gleich oder verschieden gewählt aus der Gruppe bestehend aus Pt(II), Pd(II), Ni(II), Ir(I), Rh(I), Mo(0), W(0), Re(I), Ru(II) oder Os(II), wobei sich die Angabe in Klammern jeweils auf die Oxidationsstufe des Metalls bezieht.

Geeignete Kombinationen der Metalle M¹ und M² sind also Pt(II) + Pt(II), Pt(II) + Pd(II), Pt(II) + Ni(II), Pt(II) + Ir(I), Pt(II) + Rh(I), Pt(II) + Mo(0), Pt(II) + W(0), Pt(II) + Re(I), Pt(II) + Ru(II), Pt(II) + Os(II), Pd(II) + Pd(II), Pd(II) + Ni(II), Pd(II) + Ir(I), Pd(II) + Rh(I), Pd(II) + Mo(0). Pd(II) + W(0), Pd(II) + Re(I), Pd(II) + Ru(II), Pd(II) + Os(II). Ni(II) + Ni(II), Ni(II) + Ir(I), Ni(II) + Rh(I), Ni(II) + Mo(0), Ni(II) + W(0), Ni(II) + Re(I), Ni(II) + Ru(II), Ni(II) + Os(II), Ir(I) + Ir(I), Ir(I) + Rh(I), Ir(I) + Mo(0), Ir(I) + W(0), Ir(I) + Re(I), Ir(I) + Ru(II), Ir(I) + Os(II), Rh(I) + Rh(I), Rh(I) + Mo(0), Rh(I) + W(0), Rh(I) + Re(I), Rh(I) + Ru(II), Rr(I) + Os(II), Mo(0) + Mo(0), Mo(0) + W(0), Mo(0) + Re(I), Mo(0) + Ru(II), Mo(0) + Os(II), W(0) + W(0), W(0) + Re(I), W(0) + Ru(II), W(0) + Os(II), Re(I) + Re(I), Re(I) + Ru(II), Re(I) + Os(II), Ru(II) + Ru(II), Ru(II) + Os(II) und Os(II) + Os(II).

In einer besonders bevorzugten Ausführungsform der Erfindung ist M¹= Pt(II) und M² ist gewählt aus der Pt(II), Pd(II), Ni(II), Ir(I), Rh(I), Mo(0), W(0), Re(I), Ru(II) oder Os(II). Ganz besonders bevorzugt sind M¹ und M² Pt(II).

In einer weiteren bevorzugten Ausführungsform der Erfindung sind die koordinierenden Atome X gleich Phosphor oder gleich Arsen, besonders bevorzugt gleich Phosphor.

Eine bevorzugte Ausführungsform der Erfindung ist also eine organische Elektrolumineszenzvorrichtung enthaltend mindestens eine Verbindung der Formel (2), 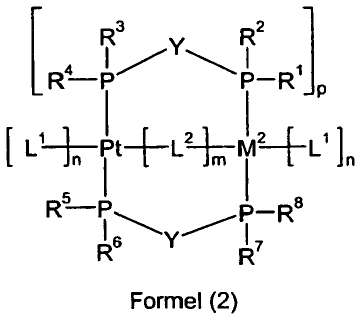 wobei M², L¹, L², Y, R¹ bis R⁸, m, n und p die oben genannten Bedeutungen haben. Dabei steht p bevorzugt für 1.

In einer bevorzugten Ausführungsform der Erfindung stehen die Reste R¹ bis R⁸ nicht für ein aromatisches oder heteroaromatisches Ringsystem.

In einer bevorzugten Ausführungsform der Formel (1) bzw. Formel (2) sind die Reste R¹ bis R⁸ bei jedem Auftreten gleich oder verschieden gewählt aus der Gruppe bestehend aus F, Si(R⁹)₃, einer geradkettigen Alkyl- oder Alkoxygruppe mit 1 bis 10 C-Atomen oder einer verzweigten oder cyclischen Alkyl- oder Alkoxygruppe mit 3 bis 10 C-Atomen, die jeweils mit einem oder mehreren Resten R¹⁰ substituiert sein kann, wobei eine oder mehrere nicht benachbarte CH₂-Gruppen, welche nicht direkt an X binden, durch C=O, O, S oder CONR¹⁰ ersetzt sein können und wobei ein oder mehrere H-Atome durch D oder F ersetzt sein können, oder eine Alkenylgruppe mit 2 bis 10 C-Atomen, oder eine Aralkyl- oder Heteroaralkylgruppe mit 5 bis 20 aromatischen Ringatomen, die durch einen oder mehrere Reste R¹⁰ substituiert sein kann, oder eine Aryloxy- oder Heteroaryloxygruppe mit 5 bis 20 aromatischen Ringatomen, die durch einen oder mehrere Reste R¹⁰ substituiert sein kann; dabei können R¹ und R², R³ und R⁴, R⁵ und R⁶ und/oder R⁷ und R⁸ auch miteinander ein mono-oder polycyclisches Ringsystem bilden. In einer besonders bevorzugten Ausführungsform der Erfindung sind die Reste R¹ bis R⁸ bei jedem Auftreten gleich oder verschieden gewählt aus der Gruppe bestehend aus F oder einer geradkettigen Alkylgruppe mit 1 bis 5 C-Atomen oder einer verzweigten oder cyclischen Alkylgruppe mit 3 bis 6 C-Atomen, wobei ein oder mehrere H-Atome durch D oder F ersetzt sein können, oder einer Alkenylgruppe mit 2 bis 5 C-Atomen, oder einer Aralkylgruppe mit 7 bis 15 C-Atomen; dabei können R¹ und R², R³ und R⁴, R⁵ und R⁶ und/oder R⁷ und R⁸ auch miteinander ein mono- oder polycyclisches Ringsystem bilden. Besonders bevorzugte Gruppen R¹ bis R⁸ sind F, Si(CH₃)₃, Methyl, Trifluormethyl, Ethyl, Vinyl, n-Propyl, Allyl, i-Propyl, n-Butyl, i-Butyl, s-Butyl, t-Butyl, t-Pentyl, Cyclopentyl, Cyclohexyl oder Benzyl, die jeweils auch miteinander ein mono- oder polycyclisches Ringsystem bilden können.

In einer weiteren bevorzugten Ausführungsform der Erfindung ist der Ligand L¹ an eine der Gruppen R¹ bis R⁸ gebunden. Dabei eignen sich als Liganden L¹ die weiter hinten aufgeführten Gruppen. Bevorzugt sind solche Ausführungsformen, in denen das Metall mit der koordinierenden Gruppe X, dem Rest R an dieser Gruppe und dem Liganden L¹ einen Vierring, einen Fünfring oder einen Sechsring bildet, bevorzugt einen Fünfring oder einen Sechsring.

Weiterhin handelt es sich bei den koordinierenden Gruppen XR¹R², XR³R⁴ und, wenn vorhanden, auch XR⁵R⁶ und XR⁷R⁸ bevorzugt jeweils um dieselbe koordinierende Gruppe, das heißt, die Reste R¹, R³, R⁵ und R⁷ sind bevorzugt gleich gewählt und die Reste R², R⁴, R⁶ und R⁸ sind bevorzugt gleich gewählt. Anders ausgedrückt, bedeutet dies, dass die Reste, die an dasselbe Atom X gebunden sind, unterschiedlich sein können, aber die beiden Seiten R₂X eines Liganden jeweils gleich sind. Diese Bevorzugung ergibt sich aus der besseren synthetischen Zugänglichkeit der Komplexe. Besonders bevorzugt sind alle Reste R¹ bis R⁸ gleich gewählt.

In einer weiteren bevorzugten Ausführungsform der Erfindung ist die Gruppe Y in Verbindungen der Formel (1) bzw. (2) gleich oder verschieden bei jedem Auftreten C(R⁹)₂, O oder N(R⁹). Ganz besonders bevorzugt ist Y gleich oder verschieden bei jedem Auftreten C(R⁹)₂. Insbesondere bevorzugt stehen alle Gruppen Y für dieselbe Gruppe C(R⁹)₂.

In einer bevorzugten Ausführungsform der Erfindung ist R⁹ für Y = C(R⁹)₂ bei jedem Auftreten gleich oder verschieden ausgewählt aus der Gruppe bestehend aus H, D, F, einer geradkettigen Alkyl- oder Alkoxygruppe mit 1 bis 10 C-Atomen oder einer verzweigten oder cyclischen Alkyl- oder Alkoxygruppe mit 3 bis 10 C-Atomen, die jeweils mit einem oder mehreren Resten R¹⁰ substituiert sein kann, wobei eine oder mehrere nicht benachbarte CH₂-Gruppen durch C=O, O, S oder CONR¹⁰ ersetzt sein können und wobei ein oder mehrere H-Atome durch D oder F ersetzt sein können, oder ein aromatisches oder heteroaromatisches Ringsystem mit 5 bis 20 aromatischen Ringatomen, das jeweils durch einen oder mehrere Reste R¹⁰ substituiert sein kann, oder eine Aryloxy- oder Heteroaryloxygruppe mit 5 bis 20 aromatischen Ringatomen, die durch einen oder mehrere Reste R¹⁰ substituiert sein kann; dabei können zwei Reste R⁹, welche an dasselbe Atom gebunden sind, miteinander ein mono- oder polycyclisches, aliphatisches, aromatisches und/oder benzoannelliertes Ringsystem bilden. In einer besonders bevorzugten Ausführungsform der Erfindung ist R⁹ bei jedem Auftreten gleich oder verschieden ausgewählt aus der Gruppe bestehend aus H, D, F, einer geradkettigen Alkylgruppe mit 1 bis 5 C-Atomen oder einer verzweigten oder cyclischen Alkylgruppe mit 3 bis 6 C-Atomen, wobei ein oder mehrere H-Atome durch D oder F ersetzt sein können, oder eine Aryl- oder Heteroarylgruppe mit 5 bis 10 aromatischen Ringatomen; dabei können zwei Reste R⁹, welche an dasselbe Atom gebunden sind, miteinander ein mono- oder polycyclisches Ringsystem bilden. Beispiele für mögliche Ringsysteme sind hier Fluoren-artige Gruppen, wenn beide Gruppen R⁹ für Phenylgruppen stehen, die miteinander ein Ringsystem bilden, oder 1,3-Dioxolane, wenn beide Gruppen R⁹ für Alkoxygruppen stehen, die miteinander ein Ringsystem bilden, oder Cycloalkylgruppen, wenn beide Gruppen R⁹ für Alkylgruppen stehen, die miteinander ein Ringsystem bilden.

Wenn Y ein Heteroatom als verbrückendes Atom enthält, beispielsweise B, Si oder N, ist R⁹, welches an dieses Heteroatom gebunden ist, bevorzugt gleich oder verschieden bei jedem Auftreten ausgewählt aus der Gruppe bestehend aus F, einer geradkettigen Alkyl- oder Alkoxygruppe mit 1 bis 10 C-Atomen oder einer verzweigten oder cyclischen Alkyl- oder Alkoxygruppe mit 3 bis 10 C-Atomen, die jeweils mit einem oder mehreren Resten R¹⁰ substituiert sein kann, wobei eine oder mehrere nicht benachbarte CH₂-Gruppen durch C=O, O, S oder CONR¹⁰ ersetzt sein können und wobei ein oder mehrere H-Atome durch D oder F ersetzt sein können, oder ein aromatisches oder heteroaromatisches Ringsystem mit 5 bis 20 aromatischen Ringatomen, das jeweils durch einen oder mehrere Reste R¹⁰ substituiert sein kann, oder eine Aryloxy- oder Heteroaryloxygruppe mit 5 bis 20 aromatischen Ringatomen, die durch einen oder mehrere Reste R¹⁰ substituiert sein kann; dabei können zwei Reste R⁹, welche an dasselbe Atom gebunden sind, miteinander ein mono- oder polycyclisches, aliphatisches, aromatisches und/oder benzoannelliertes Ringsystem bilden. In einer besonders bevorzugten Ausführungsform der Erfindung ist R⁹ dann bei jedem Auftreten gleich oder verschieden ausgewählt aus der Gruppe bestehend aus F, einer geradkettigen Alkylgruppe mit 1 bis 5 C-Atomen oder einer verzweigten oder cyclischen Alkylgruppe mit 3 bis 6 C-Atomen, wobei ein oder mehrere H-Atome durch D oder F ersetzt sein können, oder eine Aryl- oder Heteroarylgruppe mit 5 bis 10 aromatischen Ringatomen; dabei können zwei Reste R⁹, welche an dasselbe Atom gebunden sind, miteinander ein mono- oder polycyclisches Ringsystem bilden.

Besonders bevorzugt ist eine organische Elektrolumineszenzvorrichtung enthaltend mindestens eine Verbindung der Formel (3), 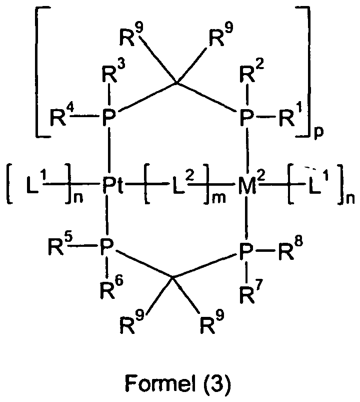 wobei M², L¹, L², R¹ bis R⁹, m, n und p die oben genannten Bedeutungen aufweisen. Dabei weisen R¹ bis R⁹ insbesondere die oben genannten bevorzugten Bedeutungen auf. p steht bevorzugt für 1.

Ganz besonders bevorzugt ist daher eine organische Elektrolumineszenzvorrichtung enthaltend mindestens eine Verbindung der Formel (4), 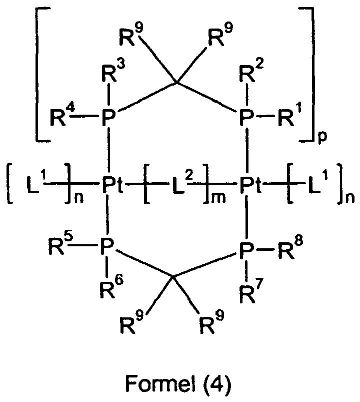 wobei L¹, L², R¹ bis R⁹, m, n und p die oben genannten Bedeutungen aufweisen. Dabei weisen R¹ bis R⁹ insbesondere die oben genannten bevorzugten Bedeutungen auf. p steht bevorzugt für 1.

Die Liganden L¹ und L² sind bevorzugt neutrale, monoanionische, dianionische oder trianionische Liganden, besonders bevorzugt neutrale oder monoanionische Liganden oder für die Liganden L² auch dianionische Liganden. Dabei sind die Liganden L¹ monodentat oder bidentat, weisen also eine oder zwei Koordinationsstellen auf, und die Liganden L² sind bidentat, weisen also zwei Koordinationsstellen auf, die gleichzeitig an M¹ und M² koordinieren. Wenn der Ligand L¹ bidentat ist, koordiniert er mit beiden Koordinationsstellen an dasselbe Metall M¹ oder M²_{.}

Geeignete neutrale, monodentate Liganden L' sind ausgewählt aus Kohlenmonoxid, Stickstoffmonoxid, Isonitrilen, wie z. B. *tert*-Butyl-isonitril, Cyclohexylisonitril, Adamantylisonitril, Phenylisonitril, Mesitylisonitril, 2,6-Dimethylphenylisonitril, 2,6-Di-*iso*-propylphenylisonitril, 2,6-Di-*tert*-butylphenylisonitril, Aminen, wie z. B. Trimethylamin, Triethylamin, Morpholin, Phosphinen, wie z. B. Trifluorphosphin, Trimethylphosphin, Tricyclohexylphosphin, Tri-*tert*-butylphosphin, Triphenylphosphin, Tris(pentafluorphenyl)phosphin, Phosphiten, wie z. B. Trimethylphosphit, Triethylphosphit, Arsinen, wie z. B. Trifluorarsin, Trimethylarsin, Tricyclohexylarsin, Tri-tert-butylarsin, Triphenylarsinin, Tris(pentafluorphenyl)arsin, Stibinen, wie z. B. Trifluorstibin, Trimethytstibin, Tricyclohexylstibin, Tri-tert-butylstibin, Triphenylstibin, Tris(pentafluorphenyl)stibin, stickstoffhaltigen Heterocyclen, wie z. B. Pyridin, Pyridazin, Pyrazin, Pyrimidin, Triazin, Ethern, wie z. B. Dimethylether, Diethylether, aliphatischen oder aromatischen Sulfiden, wie z. B. Dimethylsulfid, Diethylsulfid, oder aliphatischen oder aromatischen Seleniden, wie z. B. Dimethylselenid, Diethylselenid.

Geeignete monoanionische, monodentate Liganden L¹ sind ausgewählt aus Hydrid, Deuterid, den Halogeniden F, Cl, Br und I, Azid, Alkylacetyliden, wie z. B. Methyl-C≡C⁻, tert-Butyl-C≡C⁻, Aryl- bzw. Heteroarylacetyliden, wie z. B. Phenyl-C≡C⁻, Alkyl, wie z. B. Methyl, Ethyl, *n*-Propyl, *i-*Propyl, *n*-Butyl, *s*-Butyl, *t*-Butyl, Aryl, wie z. B. Phenyl, Naphthyl, Heteroaryl, wie z. B. Pyridyl, Hydroxid, Cyanid, Cyanat, Isocyanat, Thiocyanat, Isothiocyanat, aliphatischen oder aromatischen Alkoholaten, wie z. B. Methanolat, Ethanolat, Propanolat, *iso*-Propanolat, *tert*-Butylat, Phenolat, aliphatischen oder aromatischen Thioalkoholaten, wie z. B. Methanthiolat, Ethanthiolat, Propanthiolat, iso-Propanthiolat, tert-Thiobutylat, Thiophenolat, Amiden, wie z. B. Dimethylamid, Diethylamid, Di-*iso*-propylamid, Morpholid, Carboxylaten, wie z. B. Acetat, Trifluoracetat, Propionat, Benzoat, anionischen, stickstoffhaltigen Heterocyclen, wie z. B. Pyrrolid, Imidazolid, Pyrazolid, aliphatischen und aromatischen Phosphiden PR₂⁻ oder aliphatischen oder aromatischen Seleniden SeR⁻. Dabei sind die Alkylgruppen in diesen Gruppen bevorzugt C₁-C₂₀-Alkylgruppen, besonders bevorzugt C₁-C₁₀-Alkylgruppen, ganz besonders bevorzugt C₁-C₄-Alkylgruppen. Unter einer Arylgruppe werden auch Heteroarylgruppen verstanden. Diese Gruppen sind wie oben definiert.

Geeignete di- bzw. trianionische Liganden L¹ sind O²-, S²-, Nitrene, welche zu einer Koordination der Form R-N=M führen, wobei R allgemein für einen Substituenten steht, oder N³⁻.

Geeignete neutrale oder mono- oder dianionische bidentate Liganden L¹ sind ausgewählt aus Diaminen, wie z. B. Ethylendiamin, N,N,N',N'-Tetramethylethylendiamin, Propylendiamin, N,N,N',N'-Tetramethylpropylendiamin, cis- oder trans-Diaminocyclohexan, cis- oder trans-N,N,N',N'-Tetramethyldiaminocyclohexan, Iminen, wie z. B. 2-[1-(Phenylimino)ethyl]-pyridin, 2-[1-(2-Methylphenylimino)ethyl]pyridin, 2-[1-(2,6-Di-iso-propylphenylimino)ethyl]pyridin, 2-[1-(Methylimino)ethyl]pyridin, 2-[1-(Ethylimino)-ethyl]pyridin, 2-[1-(*iso*-Propylimino)ethyl]pyridin, 2-[1-(*tert*-Butylimino)ethyl]-pyridin, Diiminen, wie z. B. 1,2-Bis(methylimino)ethan, 1,2-Bis(ethylimino)-ethan, 1,2-Bis(iso-propylimino)ethan, 1,2-Bis(*tert*-butylimino)ethan, 2,3-Bis-(methylimino)butan, 2,3-Bis(ethylimino)butan, 2,3-Bis(*iso*-propylimino butan, 2,3-Bis(*tert*-butylimino)butan, 1,2-Bis(phenylimino)ethan, 1,2-Bis(2-methylphenylimino)ethan, 1,2-Bis(2,6-di-iso-propylphenylimino)ethan, 1,2-Bis(2,6-di-*tert*-butylphenylimino)ethan, 2,3-Bis(phenylimino)butan, 2,3-Bis(2-methylphenylimino)butan, 2,3-Bis(2,6-di-*iso*-propylphenylimino)-butan, 2,3-Bis(2,6-di-*tert*-butylphenylimino)butan, Heterocyclen enthaltend zwei Stickstoffatome, wie z. B. 2,2'-Bipyridin, o-Phenanthrolin, Diphosphinen, wie z. B. Bis(diphenylphosphino)methan, Bis(diphenylphosphino)ethan, Bis(diphenylphosphino)propan, Bis(diphenylphosphino)-butan, Bis(dimethylphosphino)methan, Bis(dimethylphosphino)ethan, Bis(dimethylphosphino)propan, Bis(dimethylphosphino)butan, Bis(diethylphosphino)methan, Bis(diethylphosphino)ethan, Bis(diethylphosphino)-propan, Bis(diethylphosphino)butan, Bis(di-*tert*-butylphosphino)methan, Bis(di-*tert*-butylphosphino)ethan, Bis(*tert*-butylphosphino)propan, Bis(*tert-*butylphosphino)butan, 1,3-Diketonaten abgeleitet von 1,3-Diketonen, wie z. B. Acetylaceton, Benzoylaceton, 1,5-Diphenylacetylaceton, Dibenzoylmethan, Bis(1,1,1-tri-fluoracetyl)methan, 3-Ketonaten abgeleitet von 3-Ketoestern, wie z. B. Acetessigsäureethylester, Carboxylate, abgeleitet von Aminocarbonsäuren, wie z. B. Pyridin-2-carbonsäure, Chinolin-2-carbonsäure, Glycin, N,N-Dimethylglycin, Alanin, N,N-Dimethylamino-alanin, Salicyliminaten abgeleitet von Salicyliminen, wie z. B. Methylsalicylimin, Ethylsalicylimin, Phenylsalicylimin, Dialkoholaten abgeleitet von Dialkoholen, wie z. B. Ethylenglykol, 1,3-Propylenglykol und Dithiolaten abgeleitet von Dithiolen, wie z. B. 1,2-Ethylendithiol, 1,3-Propylendithiol.

Bevorzugt sind weiterhin bidentate monoanionische Liganden L¹, welche mit dem Metall einen cyclometallierten Fünfring oder Sechsring mit mindestens einer Metall-Kohlenstoff-Bindung aufweisen, insbesondere einen cyclometallierten Fünfring. Dies sind insbesondere Liganden, wie sie allgemein auf dem Gebiet der phosphoreszierenden Metallkomplexe für organische Elektrolumineszenzvorrichtungen verwendet werden, also Liganden vom Typ Phenylpyridin, Naphthylpyridin, Phenylchinolin, Phenylisochinolin, etc., welche jeweils durch einen oder mehrere Reste R¹ substituiert sein können. Dem Fachmann auf dem Gebiet der phosphoreszierenden Elektrolumineszenzvorrichtungen ist eine Vielzahl derartiger Liganden bekannt, und er kann ohne erfinderisches Zutun weitere derartige Liganden als Ligand L¹ für Verbindungen gemäß Formel (1) auswählen. Generell eignet sich dafür besonders die Kombination aus zwei Gruppen, wie sie durch die folgenden Formeln (5) bis (32) dargestellt sind. Generell eignen sich hierfür Kombinationen, welche über ein neutrales Stickstoffatom oder ein Carbenatom und über ein negativ geladenes Kohlenstoffatom oder ein negativ geladenes Stickstoffatom binden, aber auch Kombinationen, in denen beispielsweise zwei neutrale Stickstoffatome oder zwei negative geladene Stickstoffatome oder zwei negativ geladene Kohlenstoffatome an das Metall binden. Der Ligand L¹ kann dann aus den Gruppen der Formeln (5) bis (32) gebildet werden, indem diese Gruppen jeweils an der durch # gekennzeichneten Position aneinander binden. Die Position, an der die Gruppen an das Metall koordinieren, sind durch * gekennzeichnet. Außerdem können die Gruppen der Formeln (5) bis (32) auch an der mit # gekennzeichneten Position an X binden, also einen Rest R¹ bis R⁸ darstellen, oder sie können in dieser Position an einen der Reste R¹ bis R⁸ binden.

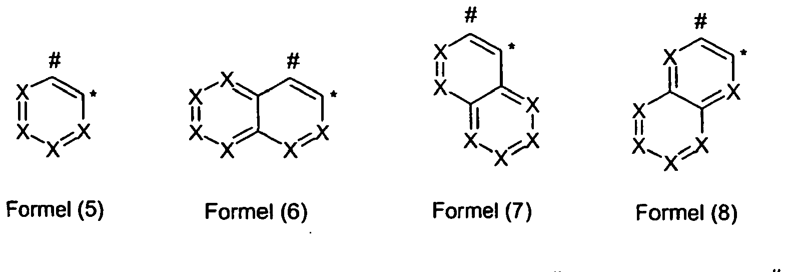

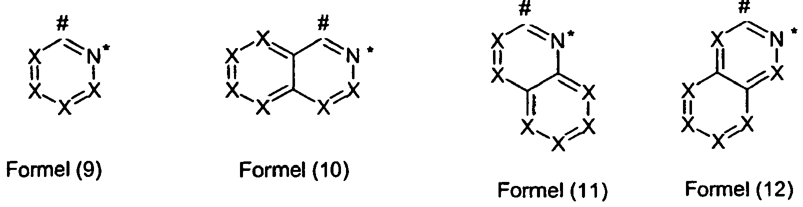

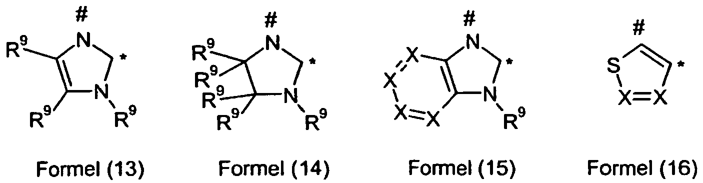

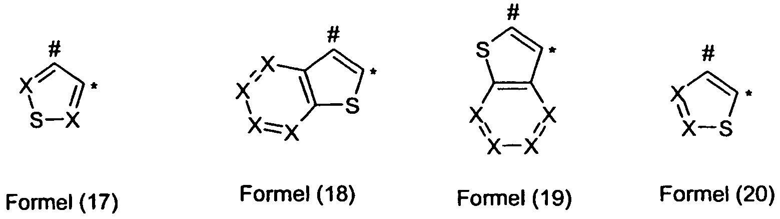

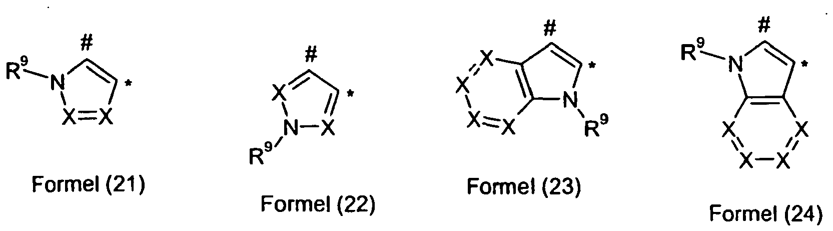

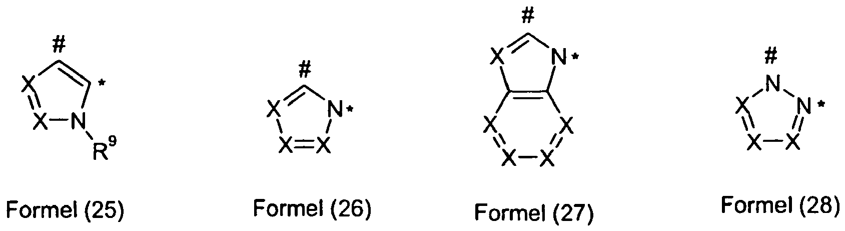

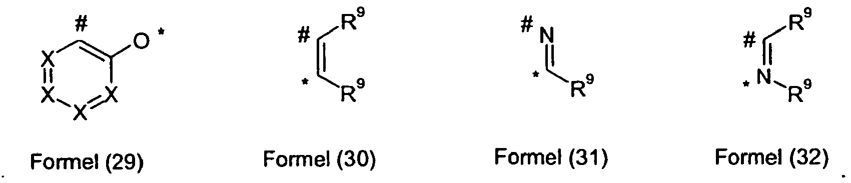

Dabei haben die verwendeten Symbole dieselbe Bedeutung, wie oben beschrieben, und X steht gleich oder verschieden bei jedem Auftreten für CR⁹ oder N mit der Maßgabe, dass maximal drei Symbole X in jeder Gruppe für N stehen. Bevorzugt stehen maximal zwei Symbole X in jeder Gruppe für N, besonders bevorzugt steht maximal ein Symbol X in jeder Gruppe für N, ganz besonders bevorzugt stehen alle Symbole X für CR⁹.

Diese oben genannten Liganden L¹ können auch mit einem der Reste R¹ bis R⁸ verknüpft sein.

Bevorzugte Liganden L¹ sind Liganden mit einem starken Ligandenfeld, insbesondere CN, CO, NO, Phosphine, wie beispielsweise die oben aufgeführten Phosphine, Acetylide und Isonitrile.

Geeignete bidentate Liganden L² sind gewählt aus der Gruppe bestehend aus H, O, S, Se, CO, C≡N, NO, Alkylgruppen, insbesondere mit 1 bis 10 C-Atomen, C(=C(R⁹)₂), -CR⁹=CR⁹-, ortho-Phenylen, Diphosphiden, Disulfide, Diphosphinen, Diaminen, Diamiden, Carbonat, Thiocarbonat, Isonitril, Acetylid oder Thiocarbonyl. Geeignete Diphosphine und Diamine sind dabei die entsprechenden oben bei L¹ aufgeführten Liganden.

Geeignet sind weiterhin Liganden L² der folgenden Formeln (33) bis (37): 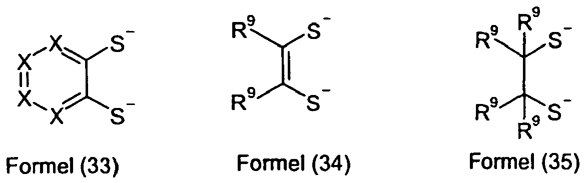 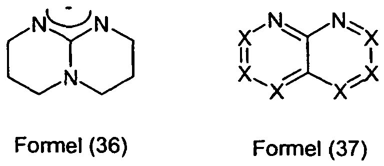 wobei die verwendeten Symbole und Indizes die oben genannten Bedeutungen aufweisen.

Bevorzugte Liganden L² sind dabei Isonitrile, Acetylide, Disulfide und CO.

Die Synthese der Komplexe gemäß Formel (1) ist in der Literatur beschrieben und dem Fachmann bekannt. So können derartige Komplexe beispielsweise in Analogie zu B.-H. Xia et al. (Inorg. Chem. 2002, 41, 3866-3875) oder die weiteren hinten in den Beispielen aufgeführte Literatur synthetisiert werden.

Die Komplexe der Formel (1) bis (4) können auch als Kern von Dendrimeren dienen. Weiterhin können diese Komplexe in Polymere eingebunden sein. Die Verknüpfung zu Polymeren kann über reative Gruppen an den Komplexen erfolgen, beispielsweise Allylgruppen oder Siloxangruppen.

Beispiele für bevorzugte Verbindungen gemäß Formel (1) sind die im Folgenden abgebildeten Verbindungen 1 bis 127. Diese Komplexe lassen sich unter anderem mit den oben erläuterten Synthesemethoden herstellen.

| | | |
|---|---|---|
| 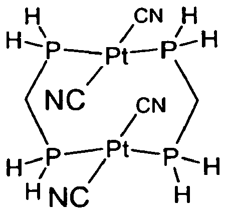 | 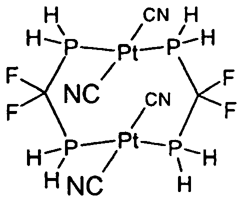 | 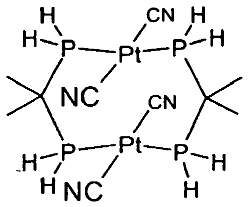 |
| 1 | 2 | 3 |
| 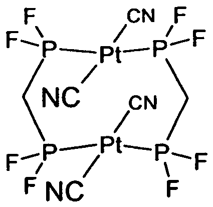 | 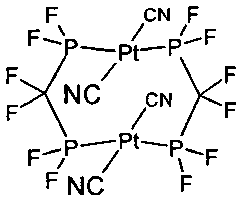 | 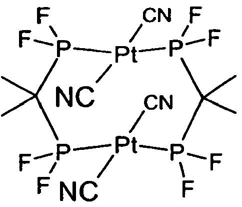 |
| 4 | 5 | 6 |
| 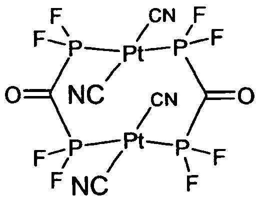 | 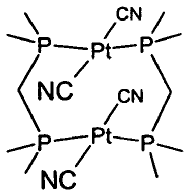 | 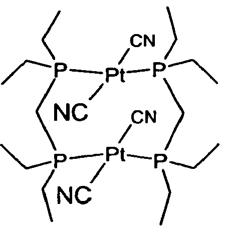 |
| 7 | 8 | 9 |
| 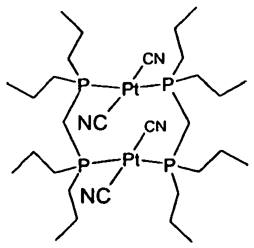 | 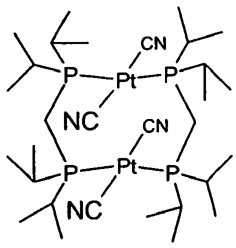 | 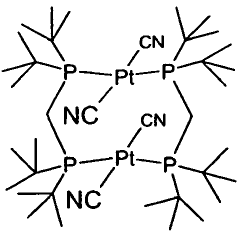 |
| 10 | 11 | 12 |
| 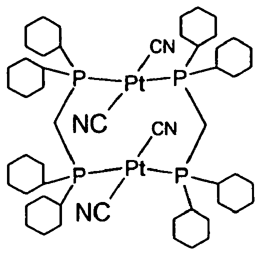 | 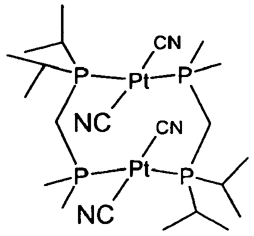 | 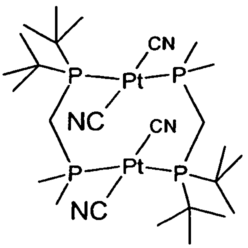 |
| 14 | 15 | 16 |
| 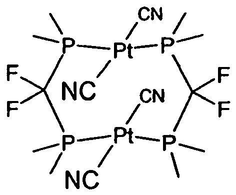 | 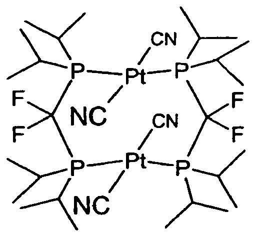 | 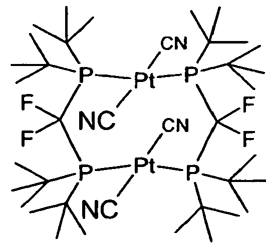 |
| 17 | 18 | 19 |
| 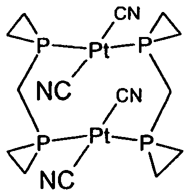 | 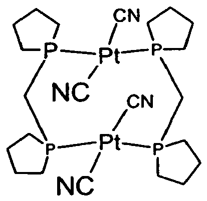 | 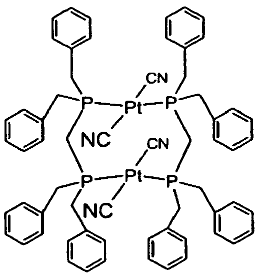 |
| 20 | 21 | 22 |
| 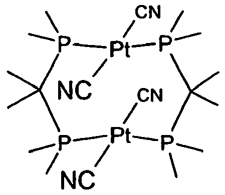 | 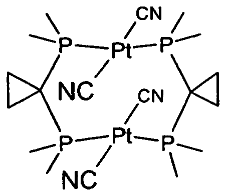 | 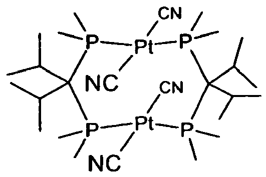 |
| 23 | 24 | 24 |
| 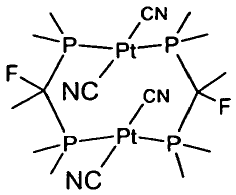 | 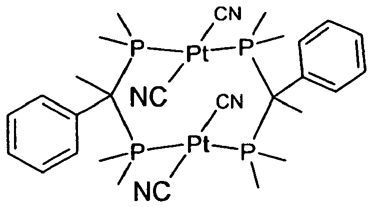 | |
| 26 | 27 | |
| 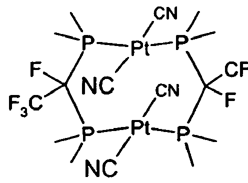 3 | 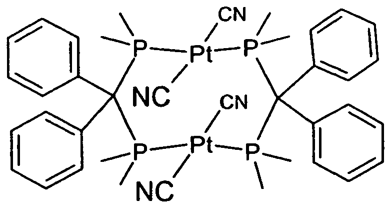 | |
| 28 | 28 | |
| 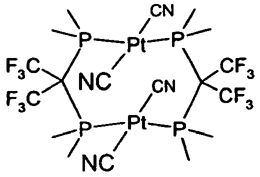 | 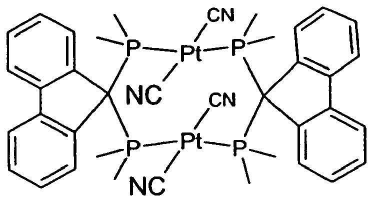 | |
| 30 | 31 | |
| 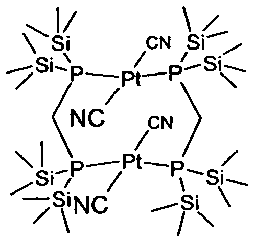 | 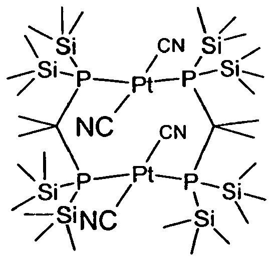 | 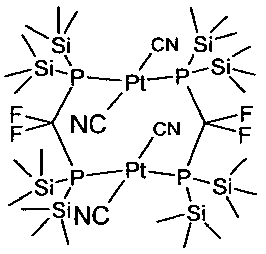 |
| 32 | 33 | 34 |
| 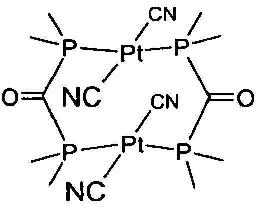 | 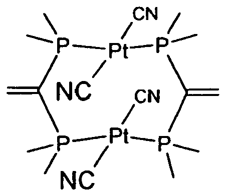 | 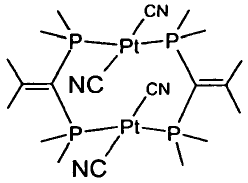 |
| 35 | 36 | 37 |
| 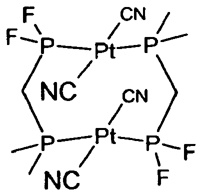 | 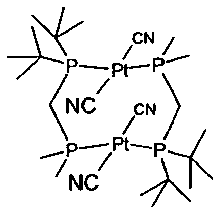 | 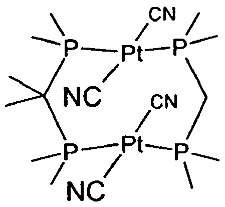 |
| 38 | 39 | 40 |
| 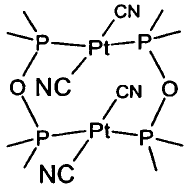 | 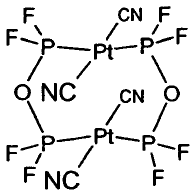 | 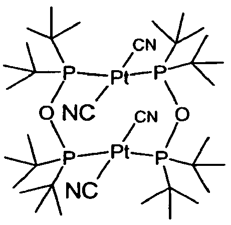 |
| 41 | 42 | 43 |
| 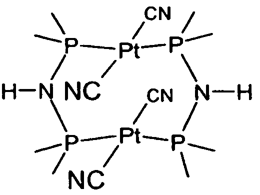 | 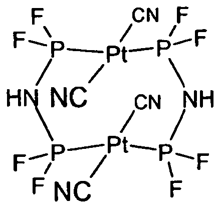 | 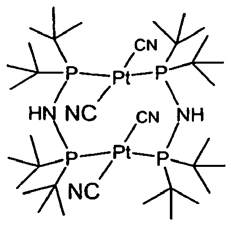 |
| 44 | 45 | 46 |
| 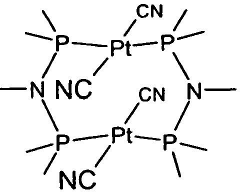 | 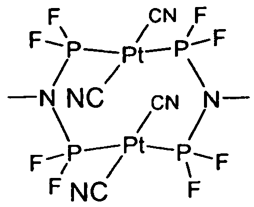 | 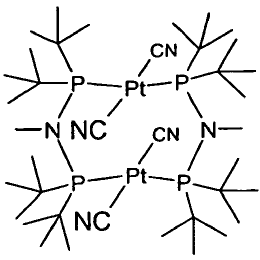 |
| 47 | 48 | 49 |
| 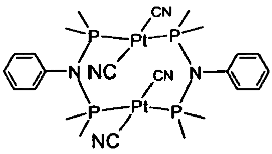 | 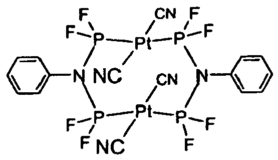 | 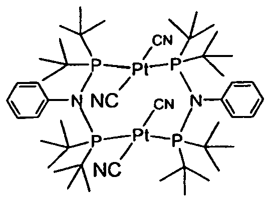 |
| 50 | 51 | 52 |
| 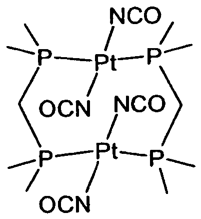 | 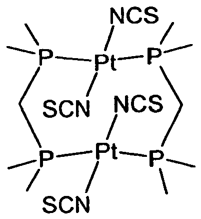 | 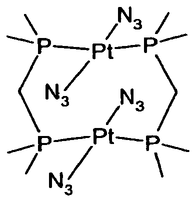 |
| 53 | 54 | 55 |
| 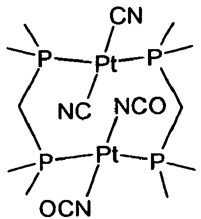 | 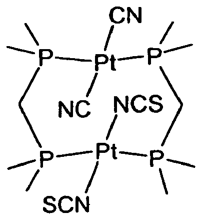 | 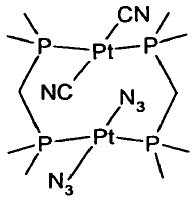 |
| 56 | 57 | 58 |
| 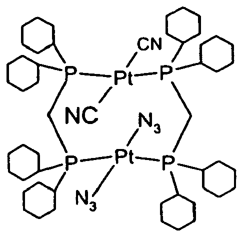 | 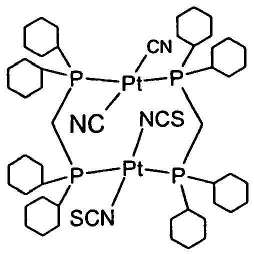 | 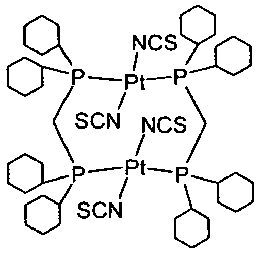 |
| 59 | 60 | 61 |
| 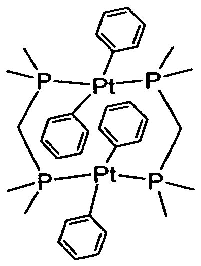 | 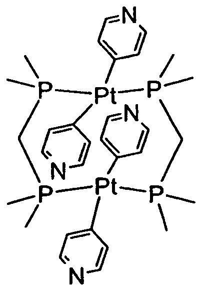 | 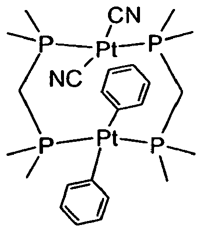 |
| 62 | 63 | 64 |
| 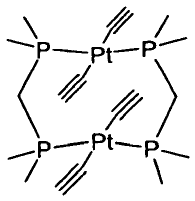 | 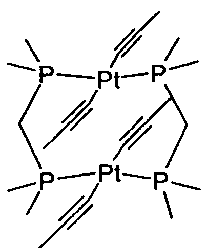 | 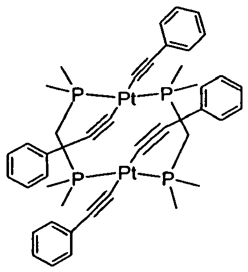 |
| 65 | 66 | 67 |
| 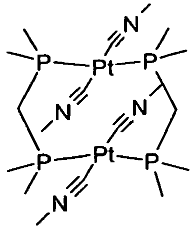 | 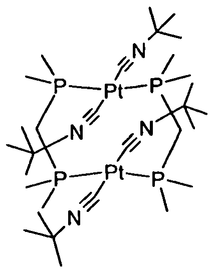 | 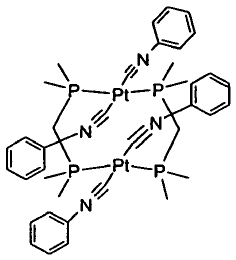 |
| 68 | 69 | 70 |
| 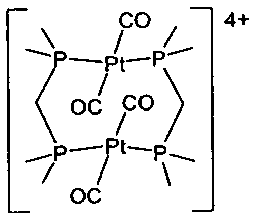 | 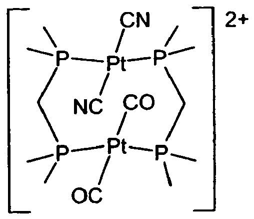 | 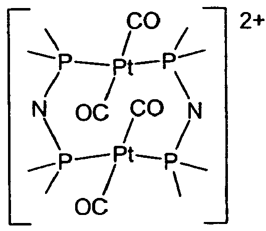 |
| 71 | 72 | 73 |
| 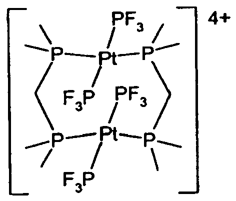 | 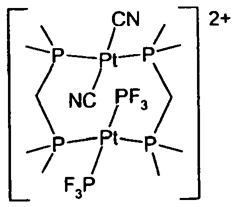 | 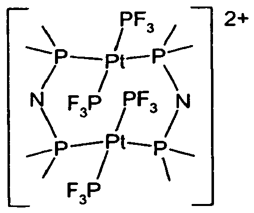 |
| 74 | 75 | 76 |
| 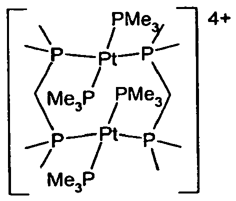 | 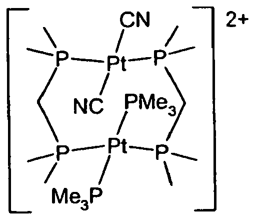 | 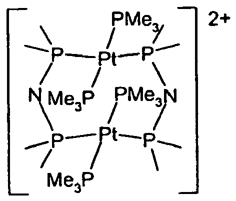 |
| 77 | 78 | 79 |
| 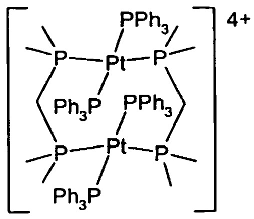 | 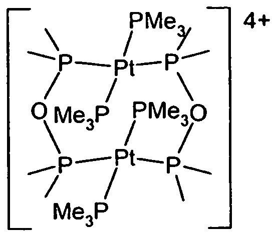 | 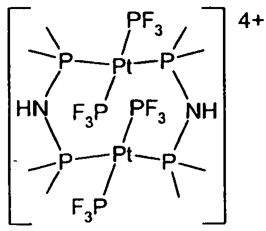 |
| 80 | 81 | 82 |
| 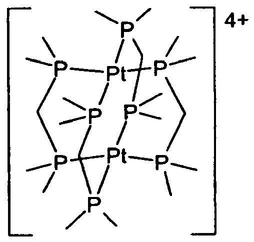 | 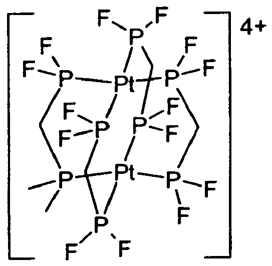 | 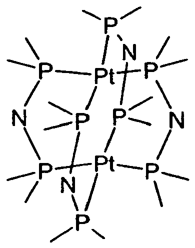 |
| 83 | 84 | 85 |
| 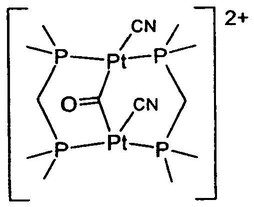 | 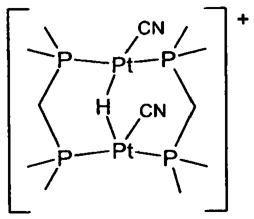 | 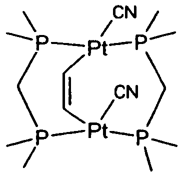 |
| 86 | 87 | 88 |
| 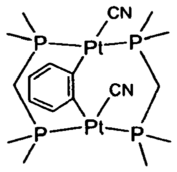 | 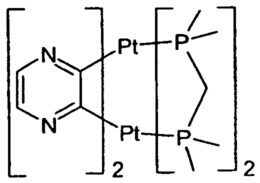 | 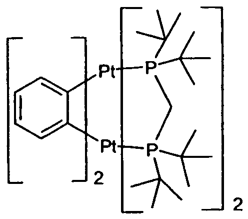 |
| 89 | 90 | 91 |
| 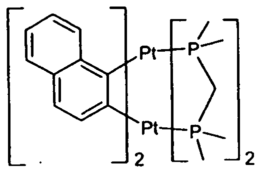 | 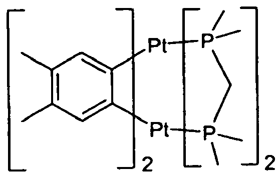 | 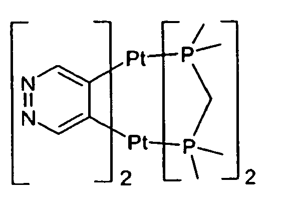 |
| 92 | 93 | 94 |
| 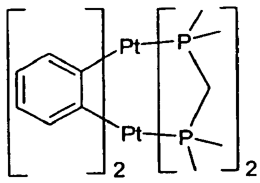 | 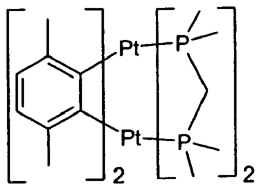 | 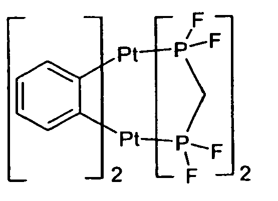 |
| 95 | 96 | 97 |
| 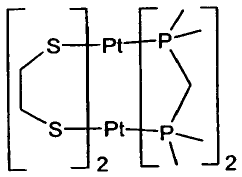 | 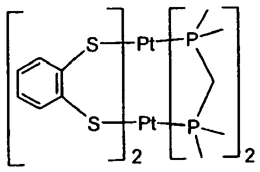 | 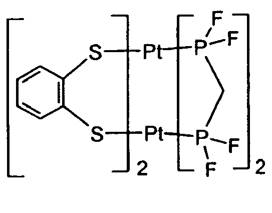 |
| 98 | 99 | 100 |
| 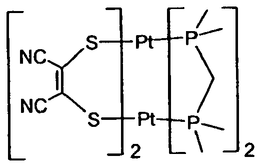 | 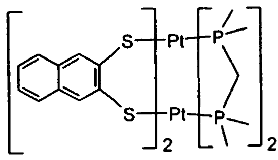 | 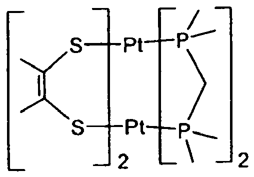 |
| 101 | 102 | 103 |
| 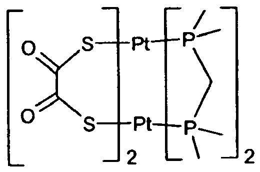 | 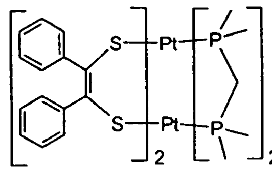 | 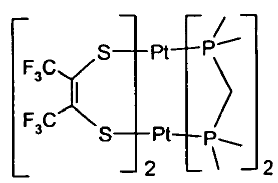 |
| 104 | 105 | 106 |
| 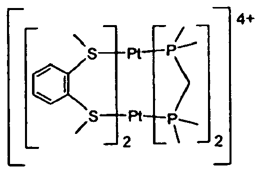 | 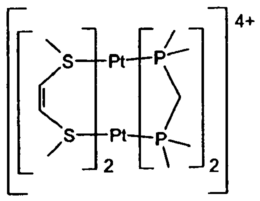 | 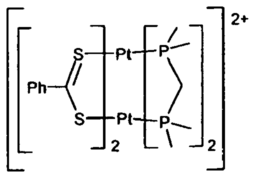 |
| 107 | 108 | 109 |
| 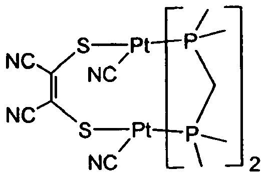 | 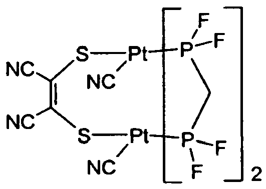 | 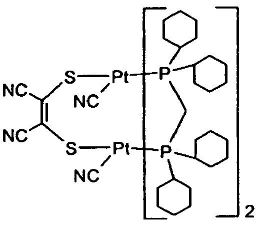 |
| 110 | 111 | 112 |
| 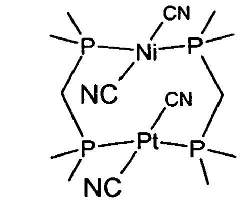 | 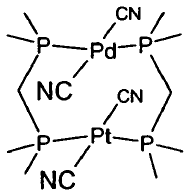 | 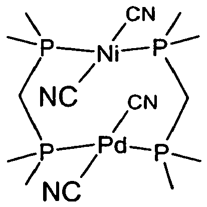 |
| 113 | 114 | 115 |
| 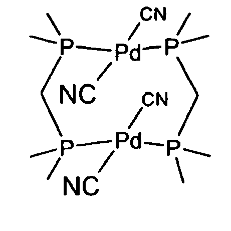 | 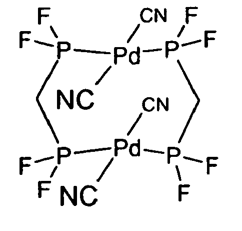 | 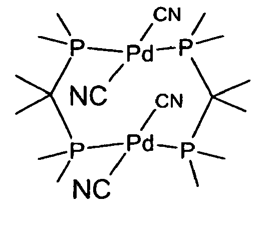 |
| 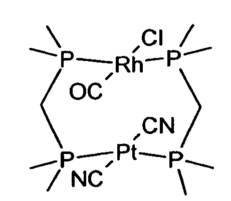 | 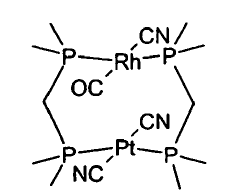 | 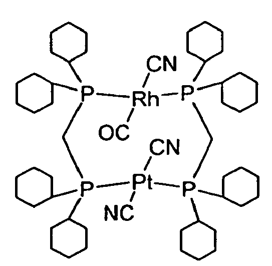 |
| 116 | 117 | 118 |
| 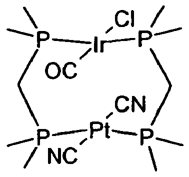 | 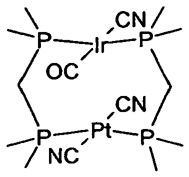 | 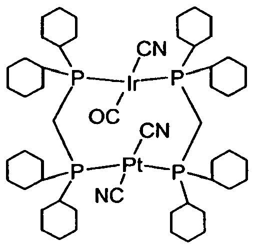 |
| 119 | 120 | 121 |
| 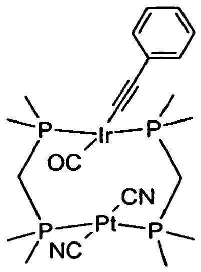 | 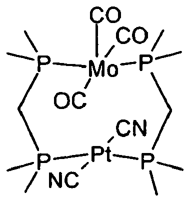 | 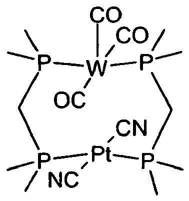 |
| 122 | 123 | 124 |
| 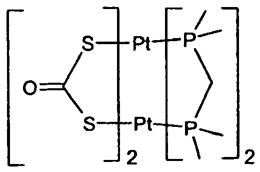 | 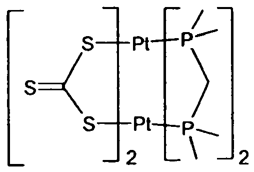 | 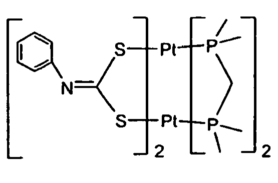 |
| 125 | 126 | 127 |

Die oben beschriebenen Komplexe gemäß Formel (1) bis (4) bzw. die oben aufgeführten bevorzugten Ausführungsformen werden in der organischen Elektrolumineszenzvorrichtung als aktive Komponente verwendet. Aktive Komponenten sind generell die organischen, metallorganischen oder anorganischen Materialien, welche zwischen Anode und Kathode eingebracht sind, beispielsweise Ladungsinjektions-, Ladungstransport- oder Ladungsblockiermaterialien, Emissionsmaterialien und Matrixmaterialien. Insbesondere als Emissionsmaterialien zeigen die erfindungsgemäßen Verbindungen besonders gute Eigenschaften, wie im Folgenden noch näher ausgeführt wird. Eine bevorzugte Ausführungsform der Erfindung sind daher organische Elektrolumineszenzvorrichtungen enthaltend mindestens eine Verbindung gemäß Formel (1) bis (4) in einer Emissionsschicht.

Die organische Elektrolumineszenzvorrichtung enthält Kathode, Anode und mindestens eine emittierende Schicht. Außer diesen Schichten kann sie noch weitere Schichten enthalten, beispielsweise jeweils eine oder mehrere Lochinjektionsschichten, Lochtransportschichten, Lochblockierschichten, Elektronentransportschichten, Elektroneninjektionsschichten, Exzitonenblockierschichten, Ladungserzeugungsschichten (Charge Generation Layers) und/oder organische oder anorganische p/n-Übergänge. Ebenso können zwischen zwei emittierende Schichten Interlayers eingebracht sein, welche beispielsweise eine Exzitonen-blockierende Funktion aufweisen. Es sei aber darauf hingewiesen, dass nicht notwendigerweise jede dieser Schichten vorhanden sein muss. Dabei kann die organische Elektrolumineszenzvorrichtung eine emittierende Schicht enthalten, oder sie kann mehrere emittierende Schichten enthalten, wobei mindestens eine emittierende Schicht mindestens eine Verbindung gemäß Formel (1) bis (4) enthält. Wenn mehrere Emissionsschichten vorhanden sind, weisen diese bevorzugt insgesamt mehrere Emissionsmaxima zwischen 380 nm und 750 nm auf, so dass insgesamt weiße Emission resultiert, d. h. in den emittierenden Schichten werden verschiedene emittierende Verbindungen verwendet, die fluoreszieren oder phosphoreszieren können. Insbesondere bevorzugt sind Dreischichtsysteme, wobei die drei Schichten blaue, grüne und orange oder rote Emission zeigen (für den prinzipiellen Aufbau siehe z. B. WO 05/011013).

Wenn die Verbindung gemäß Formel (1) bis (4) als emittierende Verbindung in einer emittierenden Schicht eingesetzt wird, wird sie bevorzugt in Kombination mit einem oder mehreren Matrixmaterialien eingesetzt. Die Mischung aus der Verbindung gemäß Formel (1) bis (4) und dem Matrixmaterial enthält zwischen 1 und 99 Vol.-%, vorzugsweise zwischen 2 und 90 Vol.-%, besonders bevorzugt zwischen 3 und 40 Vol.%, insbesondere zwischen 5 und 15 Vol.-% der Verbindung gemäß Formel (1) bis (4) bezogen auf die Gesamtmischung aus Emitter und Matrixmaterial. Entsprechend enthält die Mischung zwischen 99 und 1 Vol.-%, vorzugsweise zwischen 98 und 10 Vol.-%, besonders bevorzugt zwischen 97 und 60 Vol.-%, insbesondere zwischen 95 und 85 Vol.-% des Matrixmaterials bezogen auf die Gesamtmischung aus Emitter und Matrixmaterial.

Da die Verbindungen gemäß Formel (1) bis (4) im Allgemeinen hohe Glasübergangstemperaturen aufweisen, eignen sich sich weiterhin auch zum Einsatz als Reinschicht ohne die Verwendung eines Matrixmaterials.

Geeignete Matrixmaterialien sind Ketone, Phosphinoxide, Sulfoxide und Sulfone, z. B. gemäß WO 04/013080, WO 04/093207, WO 06/005627 oder der nicht offen gelegten Anmeldung DE 102008033943.1, Triarylamine, Carbazolderivate, z. B. CBP (N,N-Biscarbazolylbiphenyl) oder die in WO 05/039246, US 2005/0069729, JP 2004/288381, EP 1205527 oder WO 08/086851 offenbarten Carbazolderivate, Indolocarbazolderivate, z. B. gemäß WO 07/063754 oder WO 08/056746, Azacarbazole, z. B. gemäß EP 1617710, EP 1617711, EP 1731584, JP 2005/347160, bipolare Matrixmaterialien, z. B. gemäß WO 07/137725, Silane, z. B. gemäß WO 05/111172, Azaborole oder Boronester, z. B. gemäß WO 06/117052, Triazinderivate, z. B. gemäß der nicht offen gelegten Anmeldung DE 102008036982.9, WO 07/063754 oder WO 08/056746, oder Zinkkomplexe, z. B. gemäß EP 652273 oder gemäß der nicht offen gelegten Anmeldung DE 102007053771.0.

Es kann auch bevorzugt sein, eine Mischung aus mehreren Matrixmaterialien als gemischte Matrix für die Verbindung gemäß Formel (1) bis (4) zu verwenden. Besonders bevorzugt hat eine Komponente der Matrix dann elektronenleitende Eigenschaften, ist also beispielsweise ein aromatisches Keton oder ein Triazinderivat, und die andere Komponente der Matrix hat lochleitende Eigenschaften, ist also beispielsweise ein Carbazolderivat oder ein Arylamin.

In einer weiteren bevorzugten Ausführungsform der Erfindung wird die Verbindung der Formel (1) bis (4) als Co-Host für eine weitere phosphoreszierende Verbindung, die bei längerer Wellenlänge emittiert, verwendet. Dabei können als phosphoreszierende Verbindung, welche bei längerer Wellenlänge emittiert, generell alle phosphoreszierenden Materialien, wie sie gemäß dem Stand der Technik bekannt sind, verwendet werden. So kann eine Verbindung der Formel (1) bis (4), welche im blauen Bereich emittiert, als Co-Host für eine grün phosphoreszierende Verbindung eingesetzt werden und eine Verbindung, welche im grünen Bereich emittiert, als Co-Host für eine rot phosphoreszierende Verbindung. Dabei werden im Sinne der vorliegenden Erfindung alle lumineszierenden Iridium- und Platinkomplexe als phosphoreszierende Verbindungen angesehen. Als weiterer Co-Host wird besonders bevorzugt ein elektronenleitendes Matrixmaterial eingesetzt. Ein solcher Device-Aufbau ist beispielsweise allgemein in der nicht offen gelegten Anmeldung DE 102008063470.0 offenbart.

Weiterhin bevorzugt ist eine organische Elektrolumineszenzvorrichtung, dadurch gekennzeichnet, dass eine oder mehrere Schichten mit einem Sublimationsverfahren beschichtet werden. Dabei werden die Materialien in Vakuum-Sublimationsanlagen bei einem Anfangsdruck kleiner 10⁻⁵ mbar, bevorzugt kleiner 10⁻⁶ mbar aufgedampft. Es ist auch möglich, dass der Anfangsdruck noch geringer ist, beispielsweise kleiner 10⁻⁷ mbar.

Bevorzugt ist ebenfalls eine organische Elektrolumineszenzvorrichtung, dadurch gekennzeichnet, dass eine oder mehrere Schichten mit dem OVPD (Organic Vapour Phase Deposition) Verfahren oder mit Hilfe einer Trägergassublimation beschichtet werden. Dabei werden die Materialien bei einem Druck zwischen 10⁻⁵ mbar und 1 bar aufgebracht. Ein Spezialfall dieses Verfahrens ist das OVJP (Organic Vapour Jet Printing) Verfahren, bei dem die Materialien direkt durch eine Düse aufgebracht und so strukturiert werden (z. B. M. S. Arnold et al., Appl. Phys. Lett. 2008, 92, 053301).

Weiterhin bevorzugt ist eine organische Elektrolumineszenzvorrichtung, dadurch gekennzeichnet, dass eine oder mehrere Schichten aus Lösung, wie z. B. durch Spincoating, oder mit einem beliebigen Druckverfahren, wie z. B. Siebdruck, Flexodruck oder Offsetdruck, besonders bevorzugt aber LITI (Light Induced Thermal Imaging, Thermotransferdruck) oder Ink-Jet Druck (Tintenstrahldruck), hergestellt werden. Da die Verbindungen gemäß Formel (1) bis (4) im Allgemeinen eine gute Löslichkeit in den gängigen organischen Lösemitteln aufweisen, eignen sie sich gut für die Verarbeitung aus Lösung.

Diese Verfahren sind dem Fachmann generell bekannt und können von ihm ohne Probleme auf organische Elektrolumineszenzvorrichtungen enthaltend Verbindungen gemäß Formel (1) bis (4) bzw. die oben aufgeführten bevorzugten Ausführungsformen angewandt werden.

Die oben aufgeführten bevorzugten Metallkomplexe sind neu und sind daher ebenfalls Gegenstand der vorliegenden Erfindung.

Gegenstand der Erfindung sind daher Komplexe der Formel (38), 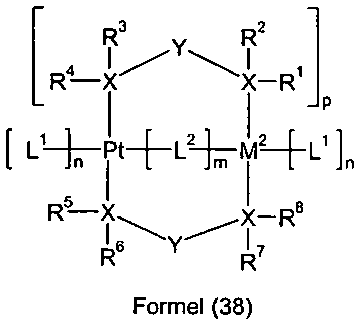 wobei M², X, Y, R¹ bis R⁸, L¹, L², m, n und p die oben genannten Bedeutungen haben;
von der Erfindung ausgenommen sind Verbindungen, in denen mindestens ein Ligand L¹ für OH, Methyl oder Phenyl steht;
von der Erfindung ausgenommen sind weiterhin die folgenden Verbindungen:

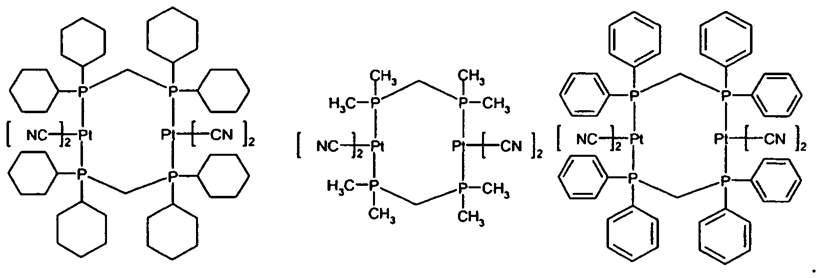

In einer bevorzugten Ausführungsform der Erfindung steht M² für Pt. Weiterhin gelten für die Verbindungen gemäß Formel (38) ebenfalls die oben für die Elektrolumineszenzvorrichtung beschriebenen bevorzugten Ausführungsformen für X, Y und R¹ bis R⁹. Insbesondere bevorzugt sind Verbindungen, in denen gleichzeitig alle der oben aufgeführten bevorzugten Ausführungsformen gelten. In einer bevorzugten Ausführungsform der Erfindung ist weiterhin p = 1, 2 oder 3, besonders bevorzugt = 1.

In einer bevorzugten Ausführungsform der Erfindung steht keiner der Liganden L¹ für Halogen. In einer weiteren bevorzugten Ausführungsform der Erfindung steht keiner der Liganden L¹ für eine Aryl- oder Alkylgruppe.

Bevorzugte Liganden L¹ und L² sind die oben bei der Elektrolumineszenzvorrichtung bereits aufgeführten Liganden.

Nochmals ein weiterer Gegenstand der vorliegenden Erfindung ist ein Verfahren zur Herstellung der Verbindungen gemäß Formel (38) durch Umsetzung eines Platinsalzes, bevorzugt K₂[PtCl₄] oder ähnliche Pt-Salze, mit einem Diphosphin zu einem Komplex (Diphosphin)PtCl₂, welcher dann mit weiteren Liganden L¹ oder L², wie oben definiert, zur Verbindung der Formel (38) umgesetzt wird.

Beispiele für die Verbindungen der Formel (38) sind die oben abgebildeten Beispielstrukturen.

Die erfindungsgemäßen organischen Elektrolumineszenzvorrichtungen zeichnen sich durch folgende überraschende Vorteile gegenüber dem Stand der Technik aus:
1. Die Verbindungen gemäß Formel (1) bis (4) und (38) weisen sowohl eine hohe thermische Stabilität auf, eignen sich also gut für die Verarbeitung aus der Gasphase, weisen aber auch eine hohe Löslichkeit in einer großen Bandbreite organischer Lösemittel auf und sind daher auch sehr gut für die Verarbeitung aus Lösung geeignet.
2. Organische Elektrolumineszenzvorrichtungen enthaltend Verbindungen gemäß Formel (1) bis (4) und (38) als emittierende Materialien weisen eine exzellente Lebensdauer auf.
3. Es sind blau phosphoreszierende Komplexe zugänglich, welche eine tiefblaue Emissionsfarbe und bei Verwendung in organischen Elektrolumineszenzvorrichtungen eine hohe Lebensdauer aufweisen. Dies ist ein Fortschritt gegenüber dem Stand der Technik, da bislang bei blau phosphoreszierenden Vorrichtungen noch Verbesserungsbedarf hinsichtlich der Farbkoordinaten und insbesondere der Lebensdauer gab. Insbesondere die scharfen Emissionsbanden der Verbindungen gemäß Formel (1) bis (4) und (38), die keine oder kaum vibronische Struktur aufweisen, führen zu sehr guten und reinen Farbkoordinaten.
4. Die erfindungsgemäßen organischen Elektrolumineszenzvorrichtungen zeigen hohe Effizienzen und steile Strom-Spannungs-Kurven.

Diese oben genannten Vorteile gehen nicht mit einer Verschlechterung der weiteren elektronischen Eigenschaften einher.

Die Erfindung wird durch die nachfolgenden Beispiele näher erläutert, ohne sie dadurch einschränken zu wollen. Der Fachmann kann, ohne erfinderisch tätig zu werden, die Erfindung im gesamten offenbarten Bereich ausführen und so weitere erfindungsgemäße organische Elektrolumineszenzvorrichtungen bzw. erfindungsgemäße Komplexe herstellen.

### Beispiele:

Die folgenden Synthesen wurden in trockenen Lösemitteln unter einer Inertgasatmosphäre und unter Ausschluss von Licht durchgeführt, sofern nichts anderes erwähnt ist. Die Lösemittel und Reagenzien können von ALDRICH oder ABCR erhalten werden.

### Vorstufen:

Die Vorstufen können gemäß J. Chem. Soc., Dalton Trans. 1985, 279-283 synthetisiert werden, indem K₂PtCl₄ mit einem Äquivalent des entsprechenden Phosphins umgesetzt wird. Einige der Produkte zeigen eine sehr geringe Löslichkeit in organischen Lösemitteln. Diese Produkte liegen möglicherweise oligomer oder polymer vor.

| Bsp. | Phosphin | Produkt | Ausbeute |
|---|---|---|---|
| 1 | 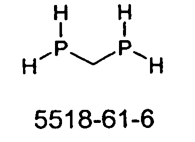 | 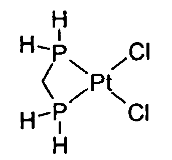 | 76,4 % |
| 2 | 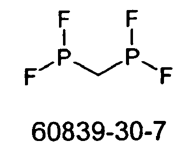 | 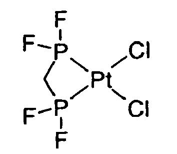 | 61.0 % |
| 3 | 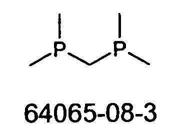 | 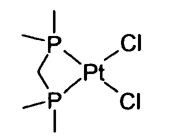 | 88,1 % |
| 4 | 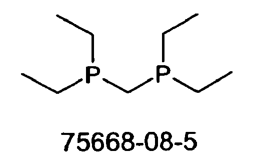 | 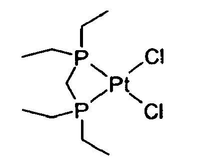 | 84,3 % |
| 5 | 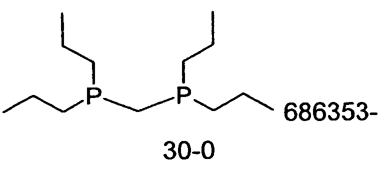 | 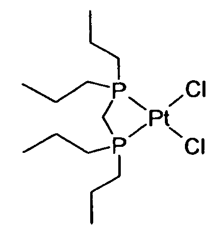 | 84,0 % |
| 6 | 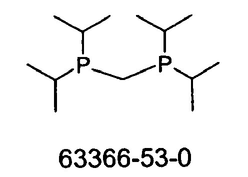 | 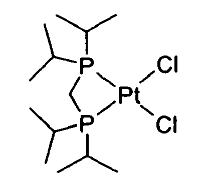 | 89,5 % |
| 7 | 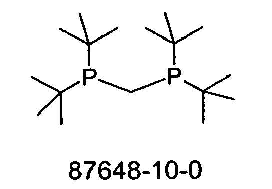 | 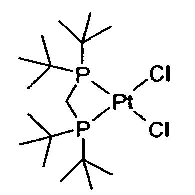 | 94,9 % |
| 8 | 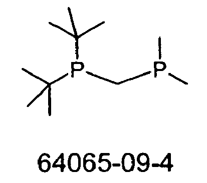 | 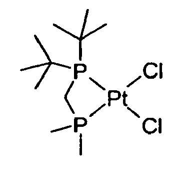 | 76,3 % |
| 9 | 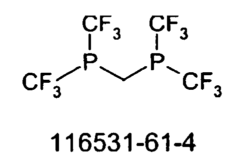 | 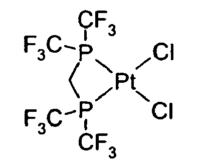 | 54.8 % |
| 10 | 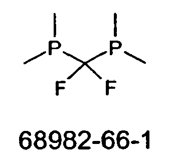 | 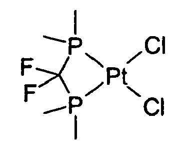 | 65,4 % |
| 11 | 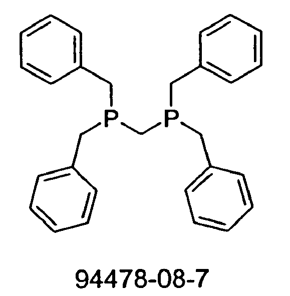 | 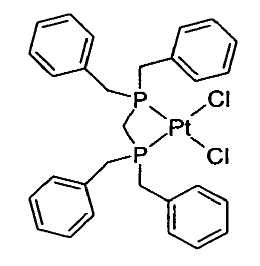 | 45,2 % |
| 12 | 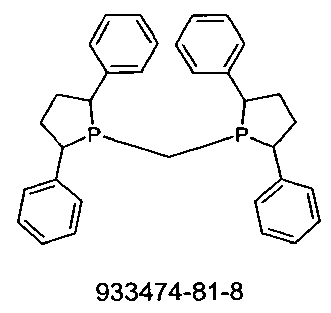 | 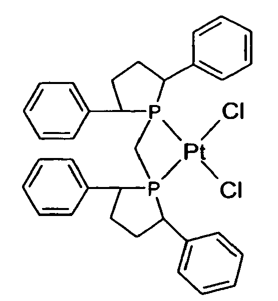 | 43,6 % |
| 13 | 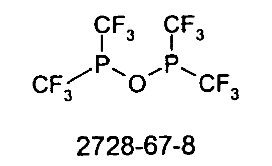 | 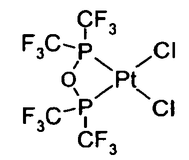 | 75,5 % |
| 14 | 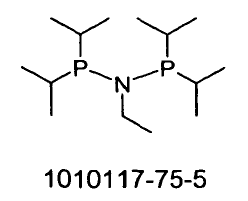 | 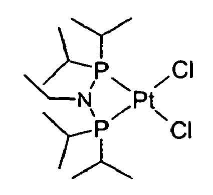 | 80,0 % |
| 15 | 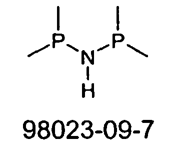 | 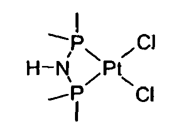 | 66,5 % |
| 16 | 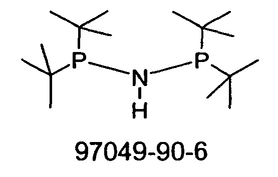 | 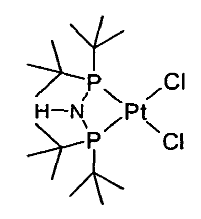 | 67,2 % |
| 17 | 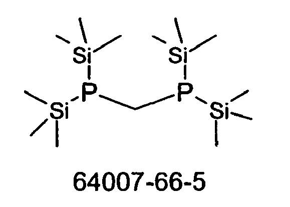 | 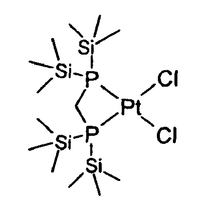 | 51,6 % |

### Beispiel: CN-Komplexe

Die folgenden Beispiele können analog zu Inorg. Chem. 2002, 41, 3866-3875 synthetisiert werden, indem die entsprechende Pt-Vorstufe mit 2 Äquivalenten NaCN in siedendem EtOH umgesetzt wird.

| Bsp. | Pt-Vorstufe | Produkt | Ausbeute |
|---|---|---|---|
| 18 | 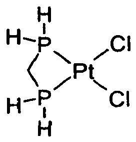 | 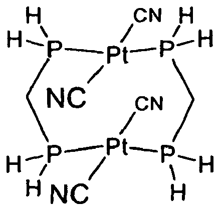 | 89,4 % |
| 19 | 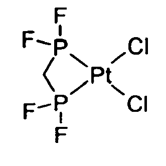 | 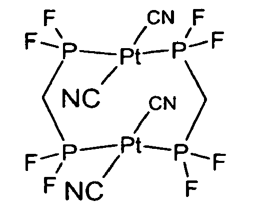 | 80,4 % |
| 20 | 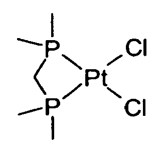 | 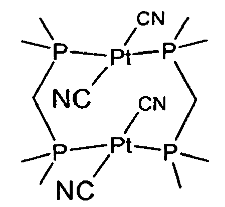 | 91,3 % |
| 21 | 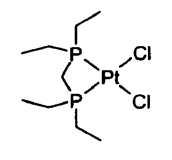 | 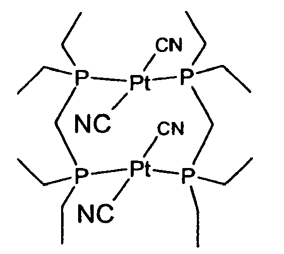 | 85,5 % |
| 22 | 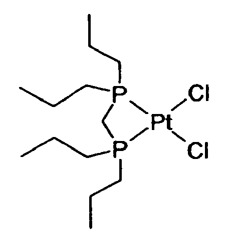 | 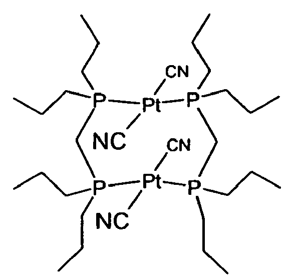 | 65,0 % |
| 23 | 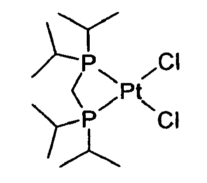 | 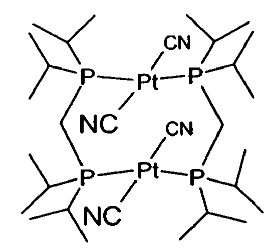 | 77,1 % |
| 24 | 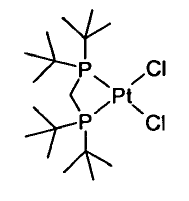 | 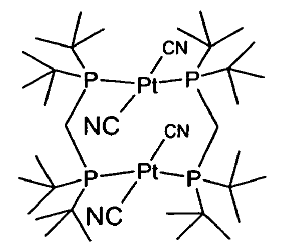 | 83,4 % |
| 25 | 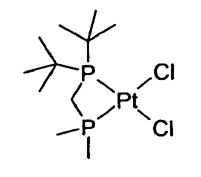 | 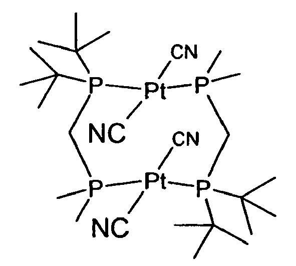 | 76,6 % |
| 26 | 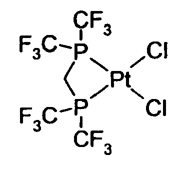 | 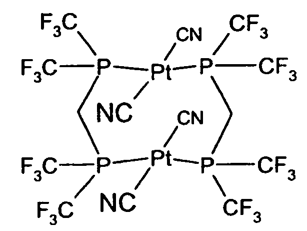 | 79,0 % |
| 27 | 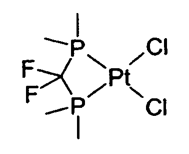 | 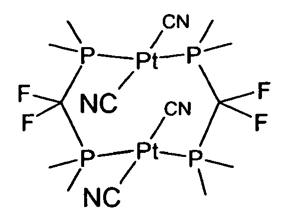 | 81,8 % |
| 28 | 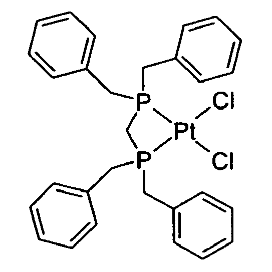 | 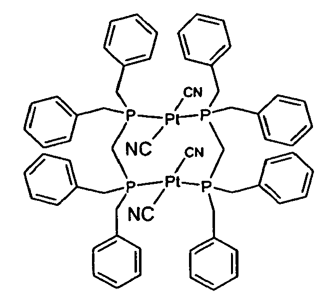 | 56,1 % |
| 28 | 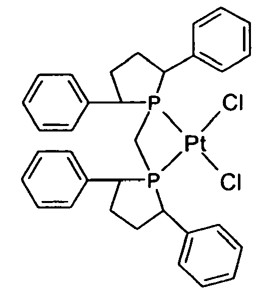 | 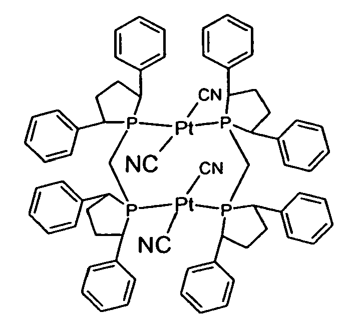 | 53,0 % |
| 29 | 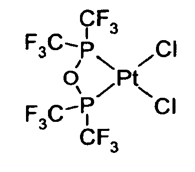 | 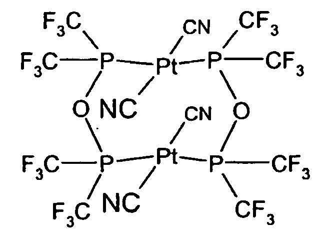 | 81,9 % |
| 30 | 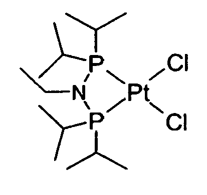 | 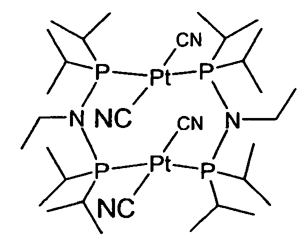 | 83,0 % |
| 31 | 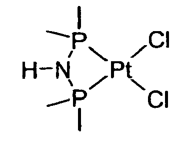 | 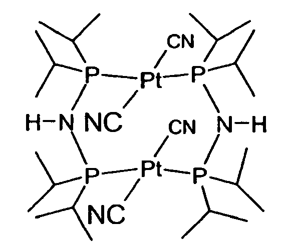 | 85,4 % |
| 32 | 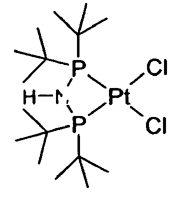 | 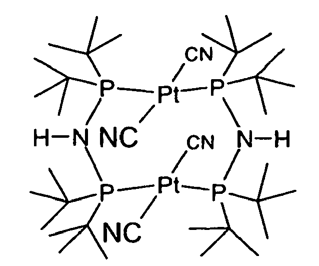 | 91,5 % |
| 33 | 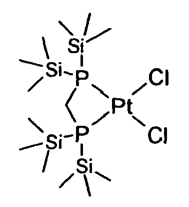 | 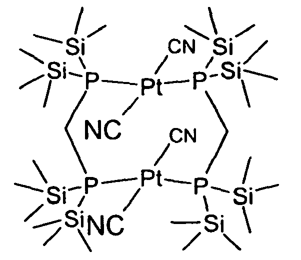 | 90,2 % |

### Beispiele: OCN-Komplexe

Die folgenden Beispiele können analog zu Inorg. Chem. 2002, 41, 3866-3875 synthetisiert werden, indem die entsprechende Pt-Vorstufe mit 2 Äquivalenten NaOCN in siedendem EtOH umgesetzt wird.

| Bsp. | Pt-Vorstufe | Produkt | Ausbeute |
|---|---|---|---|
| 34 | 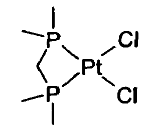 | 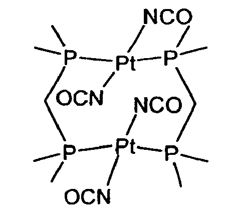 | 31,0 % |
| 35 | 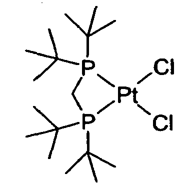 | 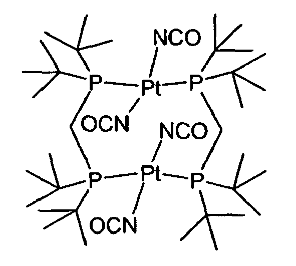 | 45,2 % |
| 36 | 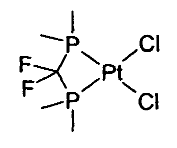 | 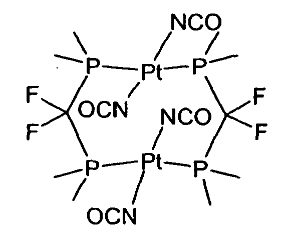 | 50,8 % |
| 37 | 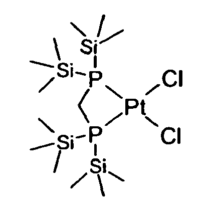 | 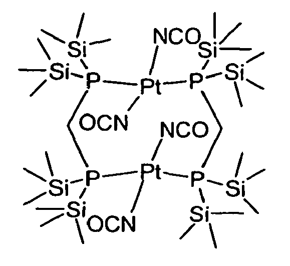 | 66,3 % |

### Beispiele: ONC-Komplexe

Die folgenden Beispiele können analog zu Inorg. Chem. 2002, 41, 3866-3875 synthetisiert werden, indem die entsprechende Pt-Vorstufe mit 2 Äquivalenten NaONC in siedendem EtOH umgesetzt wird.

| Bsp. | Pt-Vorstufe | Produkt | Ausbeute |
|---|---|---|---|
| 38 | 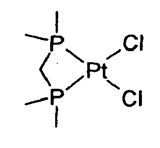 | 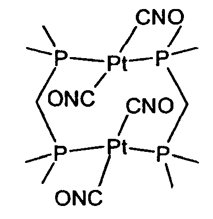 | 86,3 % |
| 39 | 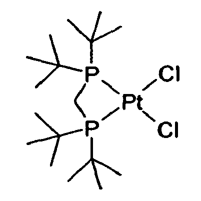 | 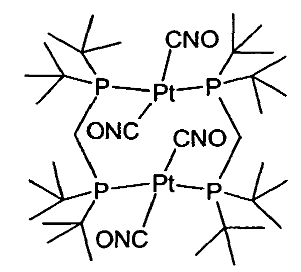 | 85,2 % |

### Beispiele: SCN-Komplexe

Die folgenden Beispiele können analog zu Inorg. Chem. 2002, 41, 3866-3875 synthetisiert werden, indem die entsprechende Pt-Vorstufe mit 2 Äquivalenten NaSCN in siedendem EtOH umgesetzt wird.

| Bsp. | Pt-Vorstufe | Produkt | Ausbeute |
|---|---|---|---|
| 40 | 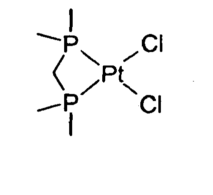 | 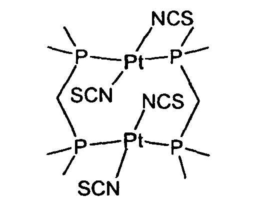 | 61,8 % |
| 41 | 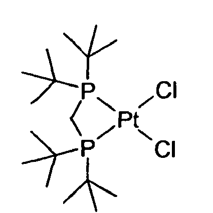 | 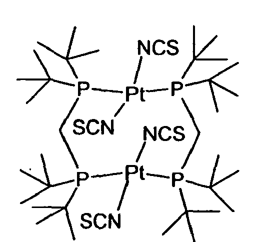 | 72,0 % |

### Beispiele: Azid-Komplexe

Die folgenden Beispiele können analog zu Inorg. Chem. 2002, 41, 3866-3875 synthetisiert werden, indem die entsprechende Pt-Vorstufe mit 2 Äquivalenten NaN₃ in siedendem EtOH umgesetzt wird.

| Bsp. | Pt-Vorstufe | Produkt | Ausbeute |
|---|---|---|---|
| 42 | 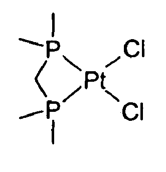 | 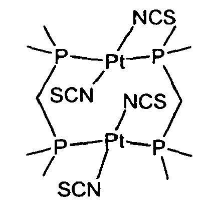 | 88,4 % |
| 43 | 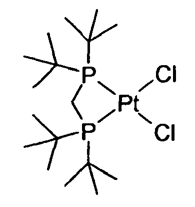 | 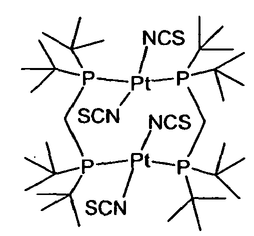 | 91,2 % |

### Beispiele: Acetylid-Komplexe

Die folgenden Beispiele können analog zu J. Chem. Soc., Dalton Trans., 1983, 2487 synthetisiert werden, indem die entsprechende Pt-Vorstufe mit 2 Äquivalenten des entsprechenden Lithiumacetylids in Toluol bei 80 °C für 24 h umgesetzt wird. 1-Propinyl-lithium kann gemäß Toussaint, D. et al., Organic Synthesis, 1999, 76 synthetisiert werden. Phenylethinyl-lithium (1 M in THF) ist von Aldrich erhältlich.

| Bsp. | Pt-Vorstufe | Produkt | Ausbeute |
|---|---|---|---|
| 44 | 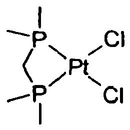 | 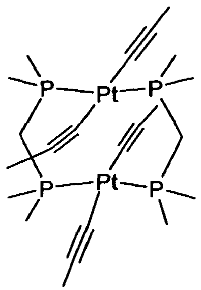 | 81,4 % |
| 45 | 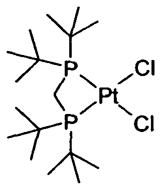 | 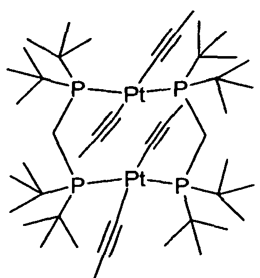 | 72,0 % |
| 46 | 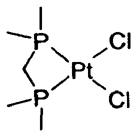 | 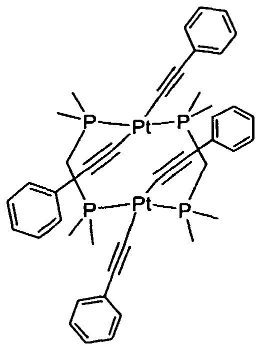 | 79,1 % |

### Beispiele: Aryl-Komplexe

Die folgenden Beispiele können synthetisiert werden, indem die entsprechende Pt-Vorstufe mit 2 Äquivalenten des entsprechenden Aryllithiums in THF bei Raumtemperatur umgesetzt wird. Phenyllithium (1.8 M in Di-n-butylether) ist von Aldrich erhältlich.

| Bsp. | Pt-Vorstufe | Produkt | Ausbeute |
|---|---|---|---|
| 47 | 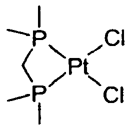 | 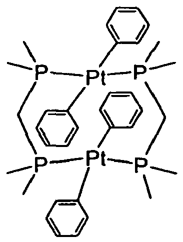 | 66,4 % |
| 48 | 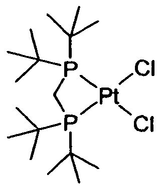 | 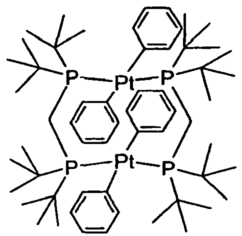 | 70,6 % |

### Beispiele: Alkyl-Komplexe

Die folgenden Beispiele können synthetisiert werden, indem die entsprechende Pt-Vorstufe mit 2 Äquivalenten des entsprechenden Alkyllithiums in THF bei Raumtemperatur umgesetzt wird. Methyllithium (1.6 M in Diethylether) ist von Aldrich erhältlich.

| Bsp. | Pt-Vorstufe | Produkt | Ausbeute |
|---|---|---|---|
| 49 | 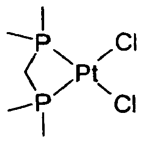 | 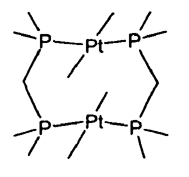 | 34,5 % |
| 50 | 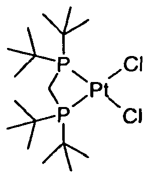 | 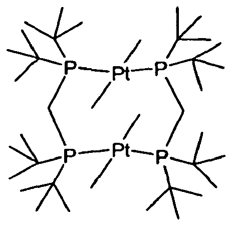 | 38,3 % |

### Beispiele: Carbonyl-Komplexe

Die folgenden Beispiele können analog zu Inorg. Chem. 2002, 41, 3866-3875 synthetisiert werden, indem die entsprechende Pt-Vorstufe unter einer Kohlenmonoxid-Atmosphäre in EtOH bei Raumtemperatur für 48 h umgesetzt wird.

| Bsp. | Pt-Vorstufe | Produkt | Ausbeute |
|---|---|---|---|
| 51 | 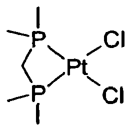 | 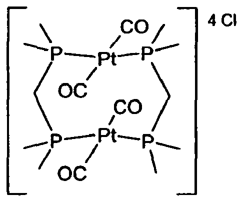 | 98,3 % |
| 52 | 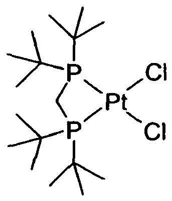 | 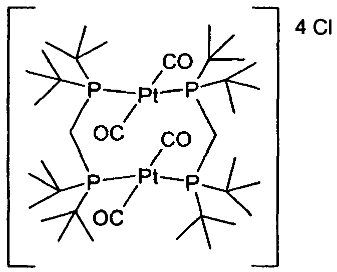 | 91,1 % |

### Beispiele: Phosphine-Komplexe

Die folgenden Beispiele können analog zu Inorg. Chem. 2002, 41, 3866-3875 synthetisiert werden, indem die entsprechende Pt-Vorstufe unter einer Trifluorphosphin-Atmosphäre in EtOH bei Raumtemperatur für 48 h oder unter Zusatz von 2 Äquivalenten des entsprechenden Monophosphins oder 1 Äquivalent des entsprechenden Diphosphins und 2 Äquivalenten Silberhexafluorophosphat unter Rühren in MeOH bei Raumtemperatur umgesetzt wird.

| Bsp. | Pt-Vorstufe | Produkt | Ausbeute |
|---|---|---|---|
| 53 | 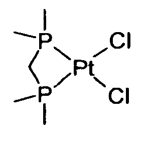 | 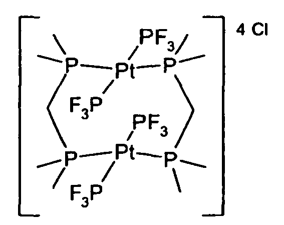 | 90,9 % |
| 54 | 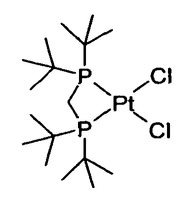 | 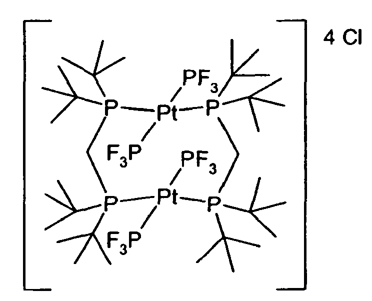 | 94,3 % |
| 55 | 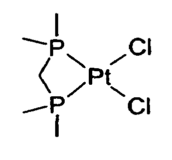 | 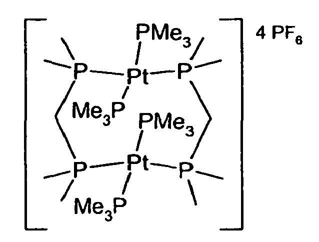 | 90,0 % |
| 56 | 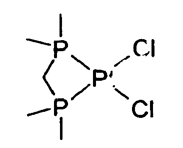 | 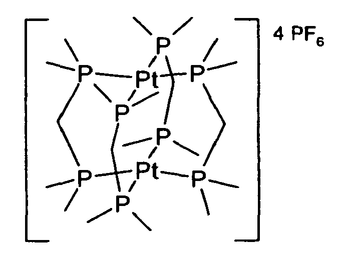 | 77,4 % |
| 57 | 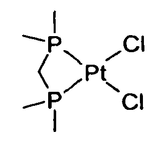 | 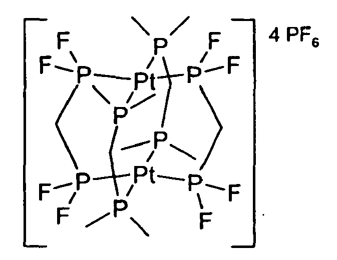 | 78,8 % |
| 58 | 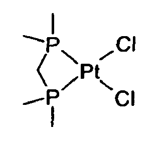 | 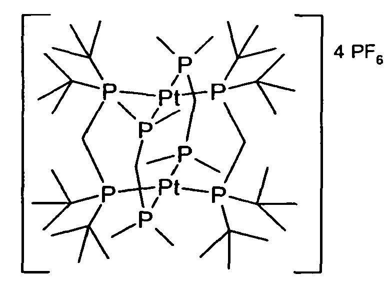 | 81,5 % |

### Beispiele: Isonitril-Komplexe

Die folgenden Beispiele können analog zu Inorg. Chem. 2002, 41, 3866-3875 synthetisiert werden, indem die entsprechende Pt-Vorstufe mit 2 Äquivalenten des entsprechenden Isonitrils in siedendem EtOH umgesetzt wird.

| Bsp. | Pt-Vorstufe | Produkt | Ausbeute |
|---|---|---|---|
| 59 | 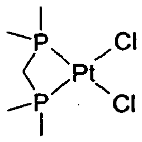 | 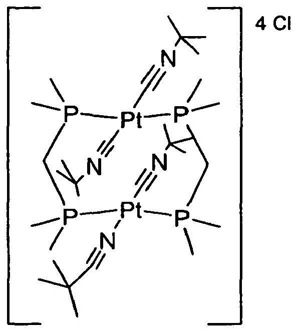 | 91,2 % |
| 60 | 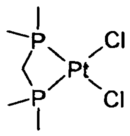 | 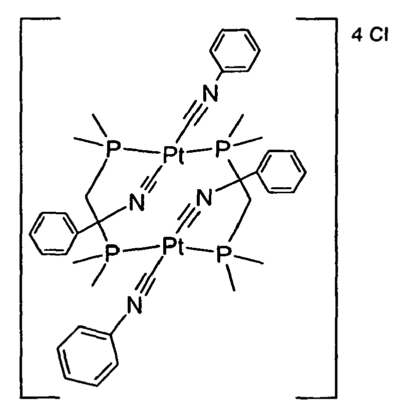 | 93,6% |

### Beispiele: Thiolat-Komplexe

Die folgenden Beispiele können analog zu Inorg. Chem. 2002, 41, 3866-3875 synthetisiert werden, indem die entsprechende Pt-Vorstufe mit 2 Äquivalenten des Natriumsalzes des entsprechenden Thiols oder 1 Äquivalent des Dinatriumsalzes des entsprechenden Dithiols in siedendem EtOH umgesetzt wird.

| Bsp. | Pt-Vorstufe | Produkt | Ausbeute |
|---|---|---|---|
| 61 | 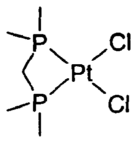 | 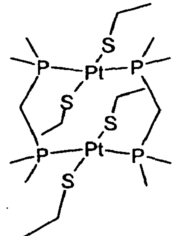 | 56,7 % |
| 62 | 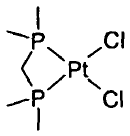 | 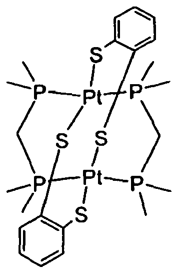 | 72,0 % |
| 63 | 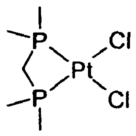 | 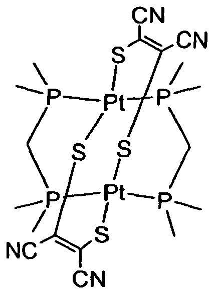 | 91.3 % |

### Beispiele: Komplexe mit gemischten Metallen

Die folgenden Beispiele können analog zu J. Chem. Soc., Dalton Trans., 1985, 279 synthetisiert werden, indem die Pt-Vorstufe [Pt(dmpm)₂]Cl₂ mit 2 Äquivalenten NaCN in Methanol bei Raumtemperatur umgesetzt wird, der sich bildende Niederschlag nach 5 h Rühren abfiltriert, mit Methanol gewaschen und im Vakuum getrocknet wird. Man erhält Pt(dmpm)₂(CN)₂ in 91 % Ausbeute. Dieses wird mit der entsprechenden Rh-, Ir-, Mo- oder W-Vorstufe, wie unten abgebildet, zum entsprechenden Komplex mit gemischten Metallen umgesetzt.

| Bsp. | Metall-Vorstufe | Produkt | Ausbeute |
|---|---|---|---|
| 64 | Rh₂Cl₂(CO)₄ | 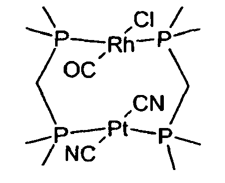 | 75,0 % |
| 65 | Ir(CO)Cl(PPh3)₂ | 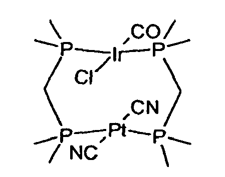 | 77,4 % |
| 66 | Mo(C₇H₈)(CO)₃ | 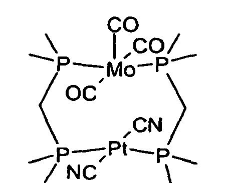 | 70,7 % |
| 67 | W(NCMe)₃(CO)₃ | 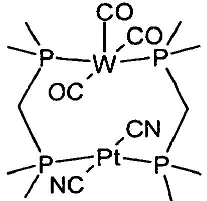 | 87,4 % |

### Beispiel 68: Herstellung und Charakterisierung von organischen Elektrolumineszenzvorrichtungen aus der Gasphase

Erfindungsgemäße Elektrolumineszenzvorrichtungen können, wie beispielsweise in WO 05/003253 beschrieben, dargestellt werden. Hier werden die Ergebnisse verschiedener OLEDs gegenübergestellt. Der grundlegende Aufbau, die verwendeten Materialien, der Dotierungsgrad und ihre Schichtdicken sind zur besseren Vergleichbarkeit identisch.

Dabei wird der folgende Device-Aufbau verwendet:

| | |
|---|---|
| Lochinjektionsschicht (HIL) | 20 nm 2,2',7,7'-Tetrakis(di-para-tolylamino)spiro-9,9'-bifluoren |
| Lochtransportschicht (HTL1) | 5 nm NPB (N-Naphthyl-N-phenyl-4,4'-diaminobiphenyl) |
| Elektronenblockierschicht (EBL) | 15 nm EBL1 oder 15 nm EBL2 |
| Emissionsschicht (EML) | Matrix M1 oder M2 oder M3 oder M4 oder Kombinationen davon, Strukturen: s. unten; 40 nm |
| | Emitter: 10 Vol.-% Dotierung |
| Elektronenleiter (ETL) | 20 nm BAlq |
| Kathode | 1 nm LiF, darauf 100 nm Al. |

Die Strukturen von EBL und M sind der Übersichtlichkeit halber im Folgenden abgebildet:

| | |
|---|---|
| 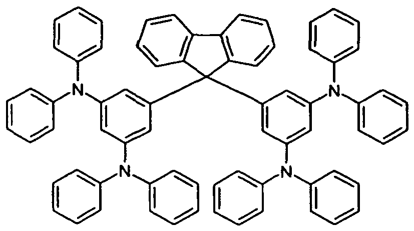 | 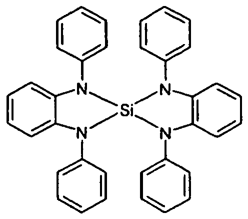 |
| EBL1 | EBL2 / M1 |
| (DE10200817591.9) | (DE10200856688.8) |
| 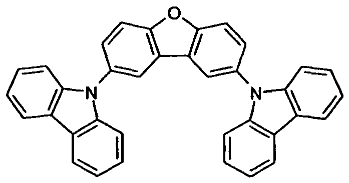 | |
| M2 | |
| CAS [913737-84-5] | |
| 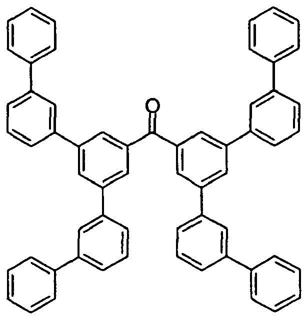 | 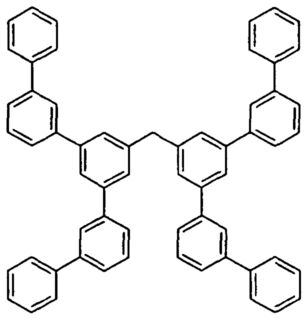 |
| M3 | M4 |
| (DE102008033943.1) | (DE102008033943.1) |

Diese noch nicht optimierten OLEDs werden standardmäßig charakterisiert; hierfür werden die Elektrolumineszenzspektren, die externe Quanteneffizienz (gemessen in %) in Abhängigkeit von der Helligkeit, berechnet aus Strom-Spannungs-Helligkeit-Kennlinien (IUL-Kennlinien) bestimmt.

**Tabelle 1: Device-Ergebnisse**

| **Bsp.** | **EBL** | **Matrix Emitter** | **EQE bei 100 cd/m² [%]** | **Spannung bei 100 cd/m² [V]** | **CIE x / y** |
|---|---|---|---|---|---|
| 69 | EBL1 | M3 | 0,7 | 7,4 | 0,09 / 0,05 |
| | | Bsp. 19 | | | |
| 70 | EBL2 | M3 | 1,0 | 6,9 | 0,14 / 0,06 |
| | | Bsp. 20 | | | |
| 71 | EBL2 | M1 (30 %) | 4,6 | 6,0 | 0,13 / 0,07 |
| | | M3 /60 %) | | | |
| | | Bsp. 20 | | | |
| 72 | EBL2 | M3 | 2,2 | 7,1 | 0,14 / 0,09 |
| | | Bsp. 24 | | | |
| 73 | EBL2 | M3 | 1,3 | 8,2 | 0,14 / 0,27 |
| | | Bsp. 26 | | | |
| 74 | EBL2 | M3 | 0,9 | 7,1 | 0,09 / 0,05 |
| | | Bsp. 27 | | | |
| 75 | EBL2 | M3 (50 %) | 3,8 | 6,7 | 0,14 / 0,10 |
| | | M4 (40 %) | | | |
| | | Bsp. 33 | | | |
| 76 | EBL2 | M3 | 1,6 | 7,2 | 0,15 / 0,11 |
| | | Bsp. 34 | | | |
| 77 | EBL2 | M3 | 1,5 | 7,4 | 0,15 / 0,17 |
| | | Bsp. 44 | | | |
| 78 | EBL2 | M3 | 2,1 | 6,9 | 0,17 / 0,22 |
| | | Bsp. 49 | | | |
| 79 | EBL2 | M3 | 6,3 | 7,0 | 0,35 / 0,55 |
| | | Bsp. 65 | | | |
| 80 | EBL1 | M2 | 5,5 | 5,9 | 0,37 / 0,59 |
| | | Bsp. 65 | | | |

### Beispiel 81: Herstellung und Charakterisierung von organischen Elektrolumineszenzvorrichtungen aus Lösung

Die Herstellung von LEDs erfolgt nach dem im Folgenden skizzierten allgemeinen Verfahren. Dieses wird im Einzelfall auf die jeweiligen Gegebenheiten (z. B. Schichtdickenvariation, um optimale Effizienz bzw. Farbe zu erreichen) angepasst.

### Allgemeines Verfahren zur Herstellung der OLEDs:

Die Herstellung solcher Bauteile lehnt sich an die Herstellung polymerer Leuchtdioden (PLEDs) an, die in der Literatur bereits vielfach beschrieben ist (z. B. in der WO 2004/037887 A2). Im vorliegenden Fall werden die erfindungsgemäßen Verbindungen zusammen mit den aufgeführten Matrixmaterialien oder Matrixmaterialkombinationen in Toluol, Chlorbenzol oder DMF gelöst. Der typische Feststoffgehalt solcher Lösungen liegt zwischen 10 und 25 g/L, wenn, wie hier, die für eine Device typische Schichtdicke von 80 nm mittels Spincoating erzielt werden soll.
Analog dem o. g. allgemeinen Verfahren werden OLEDs mit folgendem Aufbau erzeugt:

| | |
|---|---|
| PEDOT | 20 nm (aus Wasser aufgeschleudert; PEDOT bezogen von BAYER AG; Poly-[3,4-ethylendioxy-2,5-thiophen] |
| Matrix + Emitter | 80 nm, 5 Gew.-% Emitterkonzentration (aus Toluol, Chlorbenzol oder DMF aufgeschleudert), |
| Ba / Ag | 10 nm Ba / 150 nm Ag als Kathode. |

Strukturierte ITO-Substrate und das Material für die so genannte Pufferschicht (PEDOT, eigentlich PEDOT:PSS) sind käuflich erhältlich (ITO von Technoprint und anderen, PEDOT:PPS als wässrige Dispersion Clevios Baytron P von H.C. Starck). Die Emissionsschicht wird in einer Inertgasatmosphäre, im vorliegenden Fall Argon, aufgeschleudert und 10 min bei 120 °C ausgeheizt. Zuletzt wird eine Kathode aus Barium und Silber im Vakuum aufgedampft. Die lösungsprozessierten Devices werden standardmäßig charakterisiert, die genannten OLED-Beispiele sind noch nicht optimiert.

In Tabelle 2 sind die Effizienz und die Spannung bei 100 cd/m² sowie die Farbe aufgeführt.

**Tabelle 2: Device-Ergebnisse**

| **Bsp.** | **Matrix Emitter** | **EQE bei 100 cd/m² [%]** | **Spannung bei 100 cd/m² [V]** | **CIE x/y** |
|---|---|---|---|---|
| 82 | M1 (45 %) | 2,3 | 8,6 | 0,10 / 0,06 |
| | M4 (45 %) | | | |
| | Bsp. 28 | | | |
| 83 | M3 | 2,2 | 9,4 | 0,11 / 0,06 |
| | Bsp. 47 | | | |
| 84 | M3 (45 %) | 1,7 | 8,5 | 0,09 / 0,05 |
| | M4 (45 %) | | | |
| | Bsp. 52 | | | |
| 85 | M1 (20 %) | 0,5 | 8,6 | 0,09 / 0,05 |
| | M4 (70 %) | | | |
| | Bsp. 58 | | | |
| 86 | M1 (20 %) | 4,5 | 6,8 | 0,19 / 0,36 |
| | M4 (70 %) | | | |
| | Bsp. 63 | | | |
| 87 | M1 (20 %) | 0,9 | 7,2 | 0,41 / 0,46 |
| | M4 (70 %) | | | |
| | Bsp. 67 | | | |

## Patentansprüche

1. Organische Elektrolumineszenzvorrichtung, enthaltend mindestens eine Verbindung der Formel (1), 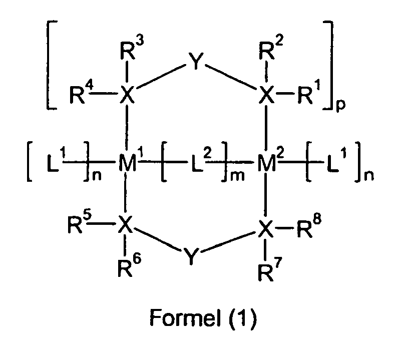 wobei für die verwendeten Symbole und Indizes gilt:
M¹, M² ist bei jedem Auftreten gleich oder verschieden ein Metall ausgewählt aus der Gruppe bestehend aus Pt, Pd, Ni, Ir, Rh, Mo, W, Re, Ru oder Os;
X ist bei jedem Auftreten gleich oder verschieden P, As, Sb oder Bi;
Y ist bei jedem Auftreten gleich oder verschieden C(R⁹)₂, Si(R⁹)₂, B(R⁹), N(R⁹), P(R⁹), O, S, Se, C(=O), C(=S), C(=NR⁹) oder C(=C(R⁹)₂);
L¹ ist bei jedem Auftreten gleich oder verschieden ein monodentater Ligand oder ein bidentater Ligand, der an eines der Metallatome M¹ bzw. M² koordiniert; dabei kann L¹ auch mit einer der Gruppen R¹ bis R³ verknüpft sein;
L² ist bei jedem Auftreten gleich oder verschieden ein bidentater Ligand, der gleichzeitig an beide Metallatome M¹ und M² koordiniert;
R¹ bis R⁸ ist bei jedem Auftreten gleich oder verschieden F, Cl, Br, I, N(R¹⁰)₂, CN, Si(R¹⁰)₃, C(=O)R¹⁰, P(R¹⁰)₂, eine geradkettige Alkyl-, Alkoxy- oder Thioalkoxygruppe mit 1 bis 40 C-Atomen oder eine geradkettige Alkenyl- oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die jeweils mit einem oder mehreren Resten R¹⁰ substituiert sein kann, wobei eine oder mehrere nicht benachbarte CH₂-Gruppen, die nicht direkt an X binden, durch R¹⁰C=CR¹⁰, C=C, Si(R¹⁰)₂, Ge(R¹⁰)₂, Sn(R¹⁰)₂, C=O, C=S, C=Se, C=NR¹⁰, P(=O)(R¹⁰), SO, SO₂, NR¹⁰, O, S oder CONR¹⁰ ersetzt sein können und wobei ein oder mehrere H-Atome durch D, F, Cl, Br, I, CN oder NO₂ ersetzt sein können, oder ein aromatisches oder heteroaromatisches Ringsystem mit 5 bis 60 aromatischen Ringatomen, das jeweils durch einen oder mehrere Reste R¹⁰ substituiert sein kann, oder eine Aralkyl- oder Heteroaralkylgruppe mit 5 bis 40 aromatischen Ringatomen, die jeweils durch einen oder mehrere Reste R¹⁰ substituiert sein kann, oder eine Aryloxy- oder Heteroaryloxygruppe mit 5 bis 40 aromatischen Ringatomen, die durch einen oder mehrere Reste R¹⁰ substituiert sein kann, oder eine Diaryl-minogruppe, Diheteroarylaminogruppe oder Arylheteroarylaminogruppe mit 10 bis 40 aromatischen Ringatomen, welche durch einen oder mehrere Reste R¹⁰ substituiert sein kann; dabei können R¹ und R², R³ und R⁴, R⁵ und R⁶ und/oder R⁷ und R⁸ auch miteinander ein mono- oder polycyclisches, aliphatisches, aromatisches und/oder benzoannelliertes Ringsystem bilden; außerdem können ein oder mehrere Reste R¹ bis R⁸ mit einem oder mehreren Liganden L¹ oder L² verknüpft sein und so einen polydentaten Liganden bilden;
R⁹ ist bei jedem Auftreten gleich oder verschieden H, D, F, Cl, Br, I, N(R¹⁰)₂, CN, NO₂, Si(R¹⁰)_{3,} B(OR¹⁰)₂, C(=O)R¹⁰, P(=O)(R¹⁰)₂, S(=O)R¹⁰, S(=O)₂R¹⁰, OSO₂R¹⁰, eine geradkettige Alkyl-, Alkoxy- oder Thioalkoxygruppe mit 1 bis 40 C-Atomen oder eine geradkettige Alkenyl- oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die jeweils mit einem oder mehreren Resten R¹⁰ substituiert sein kann, wobei eine oder mehrere nicht benachbarte CH₂-Gruppen durch R¹⁰C=CR¹⁰, C=C, Si(R¹⁰)₂, Ge(R¹⁰)₂, Sn(R¹⁰)₂, C=O, C=S, C=Se, C=NR¹⁰, P(=O)(R¹⁰), SO, SO₂, NR¹⁰, O, S oder CONR¹⁰ ersetzt sein können und wobei ein oder mehrere H-Atome durch D, F, Cl, Br, I, CN oder NO₂ ersetzt sein können, oder ein aromatisches oder heteroaromatisches Ringsystem mit 5 bis 60 aromatischen Ringatomen, das jeweils durch einen oder mehrere Reste R¹⁰ substituiert sein kann, oder eine Aralkyl- oder Heteroaralkylgruppe mit 5 bis 40 aromatischen Ringatomen, die jeweils durch einen oder mehrere Reste R¹⁰ substituiert sein kann, oder eine Aryloxy- oder Heteroaryloxygruppe mit 5 bis 40 aromatischen Ringatomen, die durch einen oder mehrere Reste R¹⁰ substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste R¹⁰ substituiert sein kann; dabei können auch zwei Reste R⁹, welche an dasselbe C- oder Si-Atom gebunden sind, miteinander ein mono- oder polycyclisches, aliphatisches, aromatisches und/oder benzoannelliertes Ringsystem bilden;
R¹⁰ ist bei jedem Auftreten gleich oder verschieden H, D, F, Cl, Br, I, N(R¹¹)_{2,} CN, NO₂, Si(R¹¹)_{3,} B(OR¹¹)₂, C(=O)R¹¹ P(=O)(R¹¹)₂, S(=O)R¹¹, S(=O)₂R¹¹, OSO₂R¹¹, eine geradkettige Alkyl-, Alkoxy- oder Thioalkoxygruppe mit 1 bis 20 C-Atomen oder eine geradkettige Alkenyl- oder Alkinylgruppe mit 2 bis 20 C-Atomen oder eine verzweigte oder cyclische Alkyl-, Alkenyl-, Alkinyl-, Alkoxy- oder Thioalkoxygruppe mit 3 bis 20 C-Atomen, die jeweils mit einem oder mehreren Resten R¹¹ substituiert sein kann, wobei eine oder mehrere nicht benachbare CH₂-Gruppen durch R¹¹C=CR¹¹, C≡C, Si(R¹¹)₂, Ge(R¹¹)₂, Sn(R¹¹)₂, C=O, C=S, C=Se, C=NR¹¹, P(=O)(R¹¹), SO, SO₂, NR¹¹, O, S oder CONR¹¹ ersetzt sein können und wobei ein oder mehrere H-Atome durch D, F, Cl, Br, I, CN oder NO₂ ersetzt sein können, oder ein aromatisches oder heteroaromatisches Ringsystem mit 5 bis 60 aromatischen Ringatomen, das jeweils durch einen oder mehrere Reste R¹¹ substituiert sein kann, oder eine Aryloxy- oder Heteroaryloxygruppe mit 5 bis 40 aromatischen Ringatomen, die durch einen oder mehrere Reste R¹¹ substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste R¹¹ substituiert sein kann; dabei können zwei oder mehrere benachbarte Reste R¹¹ miteinander ein mono- oder polycyclisches, aliphatisches oder aromatisches Ringsystem bilden;
R¹¹ ist bei jedem Auftreten gleich oder verschieden H, D, F oder ein aliphatischer, aromatischer und/oder heteroaromatischer Kohlenwasserstoffrest mit 1 bis 20 C-Atomen, in dem auch ein oder mehrere H-Atome durch F ersetzt sein können; dabei können zwei oder mehrere Substituenten R¹¹ auch miteinander ein mono- oder polycyclisches, aliphatisches oder aromatisches Ringsystem bilden;
m, n sind bei jedem Auftreten gleich oder verschieden 0, 1, 2 oder 3;
p ist 0, 1, 2 oder 3;
mit der Maßgabe, dass die Indizes m, n und p so gewählt sind, dass die Koordinationszahl an jedem der Metalle M¹ und M² vier oder fünf ergibt.

2. Organische Elektrolumineszenzvorrichtung nach Anspruch 1, **dadurch gekennzeichnet, dass** für die Indizes m, n und p gilt:
p = 0, n = 0 und m = 3; oder
p = 0, n = 1 mit L¹ = monodentater Ligand und m = 2; oder
p = 0, n = 2 mit L¹ = monodentater Ligand und m = 1; oder
p = 0, n = 1 mit L¹ = bidentater Ligand und m = 1; oder
p = 0, n = 3 mit L¹ = monodentater Ligand und m = 0; oder
p = 0, n = 2 mit L¹ = monodentater + bidentater Ligand und m = 0; oder
p = 1, n = 0 und m = 2; oder
p = 1, n = 1 mit L¹ = monodentater Ligand und m = 1; oder
p = 1, n = 2 mit L¹ = monodentater Ligand und m = 0; oder
p = 1, n = 1 mit L¹ = bidentater Ligand und m = 0; oder
p = 2, n = 1 mit L¹ = monodentater Ligand und m = 0; oder
p = 2, n = 0 und m = 1; oder
p = 3, n = 0 und m = 0; oder
p = 0, n = 1 mit L¹ = monodentater Ligand und m = 3; oder
p = 0, n = 2 mit L¹ = monodentater Ligand und m = 2; oder
p = 0, n = 1 mit L¹ = bidentater Ligand und m = 3; oder
p = 0, n = 3 mit L¹ = monodentater Ligand und m = 3; oder
p = 0, n = 2 mit L¹ = monodentater + bidentater Ligand und m = 2; oder
p = 0, n = 4 mit L¹ = bidentater Ligand und m = 0; oder
p = 0, n = 2 mit L¹ = bidentater Ligand und m = 0; oder
p = 1, n = 1 mit L¹ = monodentater Ligand und m = 2; oder
p = 1, n = 2 mit L¹ = monodentater Ligand und m = 1; oder
p = 1, n = 1 mit L¹ = bidentater Ligand und m = 1; oder
p = 1, n = 3 mit L¹ = monodentater Ligand und m = 0; oder
p = 1, n = 2 mit L¹ = monodentater + bidentater Ligand und m = 0; oder
p = 2, n = 1 mit L¹ = monodentater Ligand und m = 1; oder
p = 2, n = 2 mit L¹ = monodentater Ligand und m = 0; oder
p = 2, n = 0 und m = 2.

3. Organische Elektrolumineszenzvorrichtung nach einem oder mehreren der Ansprüche 1 bis 3, **dadurch gekennzeichnet, dass** die Metalle M¹ und M² ausgewählt sind aus den folgenden Kombinationen:
Pt(II) + Pt(II), Pt(II) + Pd(II), Pt(II) + Ni(II), Pt(II) + Ir(I), Pt(II) + Rh(I), Pt(II) + Mo(0), Pt(II) + W(0), Pt(II) + Re(I), Pt(II) + Ru(II), Pt(II) + Os(II), Pd(II) + Pd(II), Pd(II) + Ni(II), Pd(II) + Ir(I), Pd(II) + Rh(I), Pd(II) + Mo(0), Pd(II) + W(0), Pd(II) + Re(I), Pd(II) + Ru(II), Pd(II) + Os(II), Ni(II) + Ni(II), Ni(II) + Ir(I), Ni(II) + Rh(I), Ni(II) + Mo(0), Ni(II) + W(0), Ni(II) + Re(I), Ni(II) + Ru(II), Ni(II) + Os(II), Ir(I) + Ir(I), Ir(I) + Rh(I), Ir(I) + Mo(0), Ir(I) + W(0), Ir(I) + Re(I), Ir(I) + Ru(II), Ir(I) + Os(II), Rh(I) + Rh(I), Rh(I) + Mo(0), Rh(I) + W(0), Rh(I) + Re(I), Rh(I) + Ru(II), Rh(I) + Os(II), Mo(0) + Mo(0), Mo(0) + W(0), Mo(0) + Re(I), Mo(0) + Ru(II), Mo(0) + Os(II), W(0) + W(0), W(0) + Re(I), W(0) + Ru(II), W(0) + Os(II), Re(I) + Re(I), Re(I) + Ru(II), Re(I) + Os(II), Ru(II) + Ru(II), Ru(II) + Os(II) und Os(II) + Os(II).

4. Organische Elektrolumineszenzvorrichtung nach einem oder mehreren der Ansprüche 1 bis 3, **dadurch gekennzeichnet, dass** die koordinierenden Atome X gleich Phosphor oder gleich Arsen sind, bevorzugt gleich Phosphor.

5. Organische Elektrolumineszenzvorrichtung nach einem oder mehreren der Ansprüche 1 bis 4, enthaltend mindestens eine Verbindung der Formel (2), 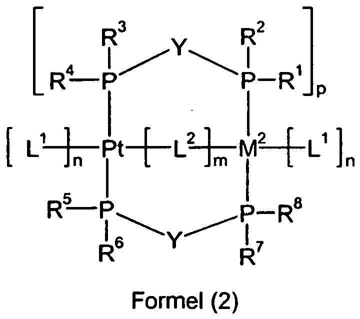 wobei M², L¹, L², Y, R¹ bis R⁸, m, n und p die in Anspruch 1 genannten Bedeutungen haben.

6. Organische Elektrolumineszenzvorrichtung nach einem oder mehreren der Ansprüche 1 bis 5, **dadurch gekennzeichnet, dass** die Reste R¹ bis R⁸ bei jedem Auftreten gleich oder verschieden ausgewählt sind aus der Gruppe bestehend aus F, Si(R⁹)₃, einer geradkettigen Alkyl- oder Alkoxygruppe mit 1 bis 10 C-Atomen oder einer verzweigten oder cyclischen Alkyl- oder Alkoxygruppe mit 3 bis 10 C-Atomen, die jeweils mit einem oder mehreren Resten R¹⁰ substituiert sein kann, wobei eine oder mehrere nicht benachbarte CH₂-Gruppen, welche nicht direkt an X binden, durch C=O, O, S oder CONR¹⁰ ersetzt sein können und wobei ein oder mehrere H-Atome durch D oder F ersetzt sein können, oder eine Alkenylgruppe mit 2 bis 10 C-Atomen, oder eine Aralkyl-oder Heteroaralkylgruppe mit 5 bis 20 aromatischen Ringatomen, die durch einen oder mehrere Reste R¹⁰ substituiert sein kann, oder eine Aryloxy- oder Heteroaryloxygruppe mit 5 bis 20 aromatischen Ringatomen, die durch einen oder mehrere Reste R¹⁰ substituiert sein kann; dabei können R¹ und R², R³ und R⁴, R⁵ und R⁶ und/oder R⁷ und R⁸ auch miteinander ein mono- oder polycyclisches Ringsystem bilden; weiterhin kann der Ligand L¹ an eine der Gruppen R¹ bis R⁸ gebunden sein.

7. Organische Elektrolumineszenzvorrichtung nach einem oder mehreren der Ansprüche 1 bis 6, enthaltend mindestens eine Verbindung der Formel (3), 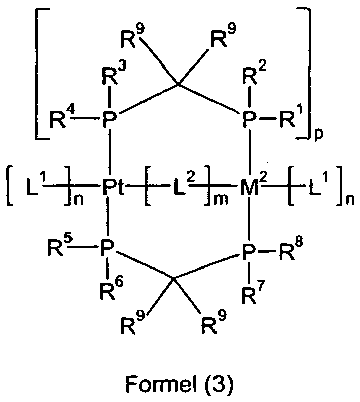 wobei M², L¹, L², R¹ bis R⁹, m, n und p die in Anspruch 1 genannten Bedeutungen aufweisen.

8. Organische Elektrolumineszenzvorrichtung nach einem oder mehreren der Ansprüche 1 bis 7, **dadurch gekennzeichnet, dass** die Liganden L¹ gleich oder verschieden bei jedem Auftreten ausgewählt sind aus Kohlenmonoxid, Stickstoffmonoxid, Isonitrilen, Aminen, Phosphinen, Phosphiten, Arsinen, Stibinen, stickstoffhaltigen Heterocyclen, Ethern, aliphatischen oder aromatischen Sulfiden, aliphatischen oder aromatischen Seleniden, Hydrid, Deuterid, F, Cl, Br und I, Azid, Alkylacetyliden, Aryl- bzw. Heteroarylacetyliden, Alkyl, Aryl, Heteroaryl, Hydroxid, Cyanid, Cyanat, Isocyanat, Thiocyanat, Isothiocyanat, aliphatischen oder aromatischen Alkoholaten, aliphatischen oder aromatischen Thioalkoholaten, Amiden, Carboxylaten, anionischen, stickstoffhaltigen Heterocyclen, aliphatischen und aromatischen Phosphiden PR₂⁻, aliphatischen oder aromatischen Seleniden SeR⁻, O²⁻, S²⁻, Nitrenen, welche zu einer Koordination der Form R-N=M führen, wobei R allgemein für einen Substituenten steht, N³⁻, Diaminen, Iminen, Heterocyclen enthaltend zwei Stickstoffatome, Diphosphinen, 1,3-Diketonaten abgeleitet von 1,3-Diketonen, 3-Ketonaten abgeleitet von 3-Ketoestern, Carboxylaten abgeleitet von Aminocarbonsäuren, Salicyliminaten abgeleitet von Salicyliminen, Dialkoholaten abgeleitet von Dialkoholen, Dithiolaten abgeleitet von Dithiolen und bidentaten monoanionischen Liganden, welche mit dem Metall einen cyclometallierten Fünfring oder Sechsring mit mindestens einer Metall-Kohlenstoff-Bindung aufweisen, wobei diese Liganden L¹ auch mit einem der Reste R¹ bis R⁸ verknüpft sein können.

9. Organische Elektrolumineszenzvorrichtung nach einem oder mehreren der Ansprüche 1 bis 8, **dadurch gekennzeichnet, dass** die Liganden L² gleich oder verschieden bei jedem Auftreten gewählt sind aus der Gruppe bestehend aus H, O, S, Se, CO, C=N, NO, Alkylgruppen, insbesondere mit 1 bis 10 C-Atomen, C(=C(R⁹)₂), -CR⁹=CR⁹-, ortho-Phenylen, Diphosphiden, Disulfide, Diphosphinen, Diaminen, Diamiden, Carbonat, Thiocarbonat, Isonitril, Acetylid, Thiocarbonyl, sowie Liganden der Formeln (33) bis (37): 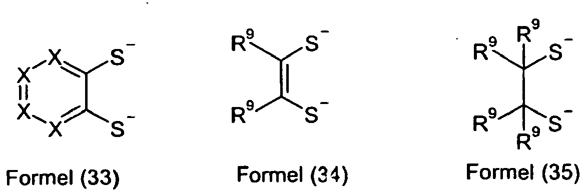 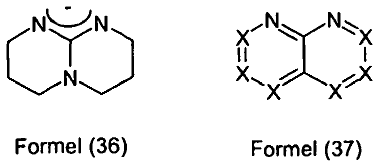 wobei R⁹ die in Anspruch 1 genannte Bedeutung aufweiset und X bei jedem Auftreten gleich oder verschieden CR⁹ oder N ist.

10. Organische Elektrolumineszenzvorrichtung nach einem oder mehreren der Ansprüche 1 bis 9, **dadurch gekennzeichnet, dass** die Komplexe der Formel (1) bis (4) als Kern von Dendrimeren dienen oder in Polymere eingebunden sind.

11. Organische Elektrolumineszenzvorrichtung nach einem oder mehreren der Ansprüche 1 bis 10, **dadurch gekennzeichnet, dass** die Verbindung gemäß Formel (1) bis (4) als Emissionsmaterial in einer Emissionsschicht eingesetzt wird, wobei sie entweder als Reinschicht oder in Kombination mit einem Matrixmaterial eingesetzt werden kann.

12. Organische Elektrolumineszenzvorrichtung nach Anspruch 11,
**dadurch gekennzeichnet, dass** das Matrixmaterial für die Verbindung der Formel (1) ausgewählt ist aus der Gruppe bestehend aus Ketonen, Phosphinoxiden, Sulfoxiden, Sulfonen, Triarylaminen, Carbazolderivaten, Indolocarbazolderivaten, Azacarbazolen, bipolaren Matrixmaterialien, Silanen, Azaborolen, Boronesternn, Triazinderivaten oder Zinkkomplexen.

13. Verfahren zur Herstellung einer organischen Elektrolumineszenzvorrichtung nach einem oder mehreren der Ansprüche 1 bis 12, **dadurch gekennzeichnet, dass** eine oder mehrere Schichten mit einem Sublimationsverfahren beschichtet werden oder dass eine oder mehrere Schichten mit dem OVPD (Organic Vapour Phase Deposition) Verfahren oder mit Hilfe einer Trägergassublimation beschichtet werden oder dass eine oder mehrere Schichten aus Lösung oder mit einem beliebigen Druckverfahren hergestellt werden.

14. Verbindung der Formel (38), 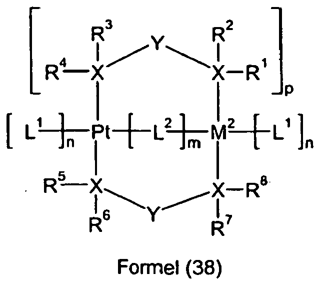 wobei M², X, Y, R¹ bis R⁸, L¹, L², m, n und p die in Anspruch 1 genannten Bedeutungen haben;
von der Erfindung ausgenommen sind Verbindungen, in denen mindestens ein Ligand L¹ für OH, Methyl oder Phenyl steht;
von der Erfindung ausgenommen sind weiterhin die folgenden Verbindungen:

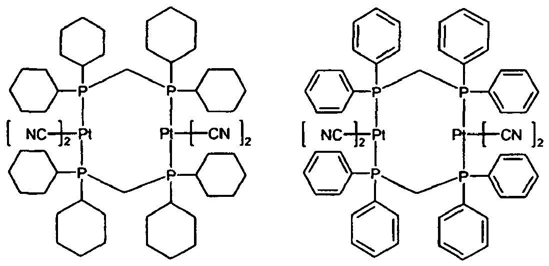

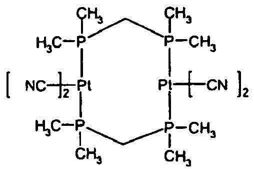

15. Verfahren zur Herstellung der Verbindungen nach Anspruch 14 durch Umsetzung eines Platinsalzes, bevorzugt K₂[PtCl₄] oder ein ähnliches Pt-Salz, mit einem Diphosphin zu einem Komplex (Diphosphin)PtCl₂, welcher dann mit Liganden L¹ oder L² zur Verbindung der Formel (38) umgesetzt wird.

## Claims

1. Organic electroluminescent device comprising at least one compound of the formula (1), 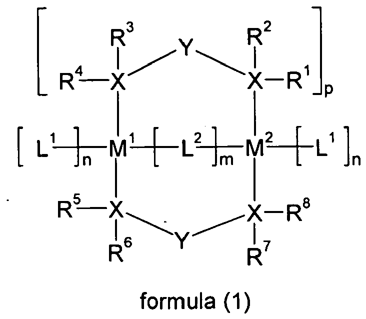 where the following applies to the symbols and indices used:
M¹, M² are on each occurrence, identically or differently, a metal selected from the group consisting of Pt, Pd, Ni, Ir, Rh, Mo, W, Re, Ru or Os;
X is on each occurrence, identically or differently, P, As, Sb or Bi;
Y is on each occurrence, identically or differently, C(R⁹)₂, Si(R⁹)₂, B(R⁹), N(R⁹), P(R⁹), O, S, Se, C(=O), C(=S), C(=NR⁹) or C(=C(R⁹)₂);
L¹ is on each occurrence, identically or differently, a monodentate ligand or a bidentate ligand which coordinates to one of the metal atoms M¹ or M²; L¹ here may also be linked to one of the groups R¹ to R⁸;
L² is on each occurrence, identically or differently, a bidentate ligand which simultaneously coordinates to both metal atoms M¹ and M²;
R¹ to R⁸ are on each occurrence, identically or differently, F, Cl, Br, I, N(R¹⁰)₂, CN, Si(R¹⁰)₃, C(=O)R¹⁰, P(R¹⁰)₂, a straight-chain alkyl, alkoxy or thioalkoxy group having 1 to 40 C atoms or a straight-chain alkenyl or alkynyl group having 2 to 40 C atoms or a branched or cyclic alkyl, alkenyl, alkynyl, alkoxy or thioalkoxy group having 3 to 40 C atoms, each of which may be substituted by one or more radicals R¹⁰, where one or more non-adjacent CH₂ groups which are not bonded directly to X may be replaced by R¹⁰C=CR¹⁰, C≡C, Si(R¹⁰)₂, Ge(R¹⁰)₂, Sn(R¹⁰)₂, C=O, C=S, C=Se, C=NR¹⁰, P(=O)(R¹⁰), SO, SO₂, NR¹⁰, O, S or CONR¹⁰ and where one or more H atoms may be replaced by D, F, Cl, Br, I, CN or NO₂, or an aromatic or heteroaromatic ring system having 5 to 60 aromatic ring atoms, which may in each case be substituted by one or more radicals R¹⁰, or an aralkyl or heteroaralkyl group having 5 to 40 aromatic ring atoms, each of which may be substituted by one or more radicals R¹⁰, or an aryloxy or heteroaryloxy group having 5 to 40 aromatic ring atoms, which may be substituted by one or more radicals R¹⁰, or a diarylamino group, diheteroarylamino group or arylheteroarylamino group having 10 to 40 aromatic ring atoms, which may be substituted by one or more radicals R¹⁰; R¹ and R², R³ and R⁴, R⁵ and R⁶ and/or R⁷ and R⁸ here may also form a mono- or polycyclic, aliphatic, aromatic and/or benzo-fused ring system with one another; in addition, one or more radicals R¹ to R⁸ may be linked to one or more ligands L¹ or L² and thus form a polydentate ligand;
R⁹ is on each occurrence, identically or differently, H, D, F, Cl, Br, I, N(R¹⁰)₂, CN, NO₂, Si(R¹⁰)₃, B(OR¹⁰)₂, C(=O)R¹⁰, P(=O)(R¹⁰)₂, S(=O)R¹⁰, S(=O)₂R¹⁰, OSO₂R¹⁰, a straight-chain alkyl, alkoxy or thioalkoxy group having 1 to 40 C atoms or a straight-chain alkenyl or alkynyl group having 2 to 40 C atoms or a branched or cyclic alkyl, alkenyl, alkynyl, alkoxy or thioalkoxy group having 3 to 40 C atoms, each of which may be substituted by one or more radicals R¹⁰, where one or more non-adjacent CH₂ groups may be replaced by R¹⁰C=CR¹⁰, C=C, Si(R¹⁰)₂, Ge(R¹⁰)₂, Sn(R¹⁰)₂, C=O, C=S, C=Se, C=NR¹⁰, P(=O)(R¹⁰), SO, SO₂, NR¹⁰, O, S or CONR¹⁰ and where one or more H atoms may be replaced by D, F, Cl, Br, I, CN or NO₂, or an aromatic or heteroaromatic ring system having 5 to 60 aromatic ring atoms, which may in each case be substituted by one or more radicals R¹⁰, or an aralkyl or heteroaralkyl group having 5 to 40 aromatic ring atoms, which may in each case be substituted by one or more radicals R¹⁰, or an aryloxy or heteroaryloxy group having 5 to 40 aromatic ring atoms, which may be substituted by one or more radicals R¹⁰, or a diarylamino group, diheteroarylamino group or arylheteroarylamino group having 10 to 40 aromatic ring atoms, which may be substituted by one or more radicals R¹⁰; two radicals R⁹ here which are bonded to the same C or Si atom may also form a mono- or polycyclic, aliphatic, aromatic and/or benzo-fused ring system with one another;
R¹⁰ is on each occurrence, identically or differently, H, D, F, Cl, Br, I, N(R¹¹)₂, CN, NO₂, Si(R¹¹)₃, B(OR¹¹)₂, C(=O)R¹¹, P(=O)(R¹¹)₂, S(=O)R¹¹, S(=O)₂R¹¹, OSO₂R¹¹, a straight-chain alkyl, alkoxy or thioalkoxy group having 1 to 20 C atoms or a straight-chain alkenyl or alkynyl group having 2 to 20 C atoms or a branched or cyclic alkyl, alkenyl, alkynyl, alkoxy or thioalkoxy group having 3 to 20 C atoms, each of which may be substituted by one or more radicals R¹¹, where one or more non-adjacent CH₂ groups may be replaced by R¹¹C=CR¹¹, C≡C, Si(R¹¹)₂, Ge(R¹¹)₂, Sn(R¹¹)₂, C=O, C=S, C=Se, C=NR¹¹, P(=O)(R¹¹), SO, SO₂, NR¹¹, O, S or CONR¹¹ and where one or more H atoms may be replaced by D, F, Cl, Br, I, CN or NO₂, or an aromatic or heteroaromatic ring system having 5 to 60 aromatic ring atoms, which may in each case be substituted by one or more radicals R¹¹, or an aryloxy or heteroaryloxy group having 5 to 40 aromatic ring atoms, which may be substituted by one or more radicals R¹¹, or a diarylamino group, diheteroarylamino group or arylheteroarylamino group having 10 to 40 aromatic ring atoms, which may be substituted by one or more radicals R¹¹; two or more adjacent radicals R¹¹ here may form a mono- or polycyclic, aliphatic or aromatic ring system with one another;
R¹¹ is on each occurrence, identically or differently, H, D, F or an aliphatic, aromatic and/or heteroaromatic hydrocarbon radical having 1 to 20 C atoms, in which, in addition, one or more H atoms may be replaced by F; two or more substituents R¹¹ here may also form a mono- or polycyclic, aliphatic or aromatic ring system with one another;
m, n are on each occurrence, identically or differently, 0, 1, 2 or 3;
p is 0, 1, 2 or 3;
with the proviso that the indices m, n and p are selected so that the coordination number on each of the metals M¹ and M² is four or five.

2. Organic electroluminescent device according to Claim 1, **characterised in that** the following applies to the indices m, n and p:
p = 0, n = 0 and m = 3; or
p = 0, n = 1 where L¹ = monodentate ligand and m = 2; or
p = 0, n = 2 where L¹ = monodentate ligand and m = 1; or
p = 0, n = 1 where L¹ = bidentate ligand and m = 1; or
p = 0, n = 3 where L¹ = monodentate ligand and m = 0; or
p = 0, n = 2 where L¹ = monodentate + bidentate ligand and m = 0; or
p = 1, n = 0 and m = 2; or
p = 1, n = 1 where L¹ = monodentate ligand and m = 1; or
p = 1, n = 2 where L¹ = monodentate ligand and m = 0; or
p = 1, n = 1 where L¹ = bidentate ligand and m = 0; or
p = 2, n = 1 where L¹ = monodentate ligand and m = 0; or
p = 2, n = 0 and m = 1; or
p = 3, n = 0 and m = 0; or
p = 0, n = 1 where L¹ = monodentate ligand and m = 3; or
p = 0, n = 2 where L¹ = monodentate ligand and m = 2; or
p = 0, n = 1 where L¹ = bidentate ligand and m = 3; or
p = 0, n = 3 where L¹ = monodentate ligand and m = 3; or
p = 0, n = 2 where L¹ = monodentate + bidentate ligand and m = 2; or
p = 0, n = 4 where L¹ = bidentate ligand and m = 0; or
p = 0, n = 2 where L¹ = bidentate ligand and m = 0; or
p = 1, n = 1 where L¹ = monodentate ligand and m = 2; or
p = 1, n = 2 where L¹ = monodentate ligand and m = 1; or
p = 1, n = 1 where L¹ = bidentate ligand and m = 1; or
p = 1, n = 3 where L¹ = monodentate ligand and m = 0; or
p = 1, n = 2 where L¹ = monodentate + bidentate ligand and m = 0; or
p = 2, n = 1 where L¹ = monodentate ligand and m = 1; or
p = 2, n = 2 where L¹ = monodentate ligand and m = 0; or
p = 2, n = 0 and m = 2.

3. Organic electroluminescent device according to one or more of Claims 1 and 2, **characterised in that** the metals M¹ and M² are selected from the following combinations:
Pt(II) + Pt(II), PT(II) + Pd(II), PT(II) + Ni(II), PT(II) + Ir(I), Pt(II) + Rh(I), Pt(II) + Mo(0), PT(II) + W(0), Pt(II) + Re(I), Pt(II) + Ru(II), Pt(II) + Os(II), Pd(II) + Pd(II), Pd(II) + Ni(II), Pd(II) + Ir(I), Pd(II) + Rh(I), Pd(II) + Mo(0), Pd(II) + W(0), Pd(II) + Re(I), Pd(II) + Ru(II), Pd(II) + Os(II), Ni(II) + Ni(II), Ni(II) + Ir(I), Ni(II) + Rh(I), Ni(II) + Mo(0), Ni(II) + W(0), NI(II) + Re(I), Ni(II) + Ru(II), Ni(II) + Os(II), Ir(I) + Ir(I), Ir(I) + Rh(I), Ir(I) + Mo(0), Ir(I) + W(0), Ir(I) + Re(I), Ir(I) + Ru(II), Ir(I) + Os(II), Rh(I) + Rh(I), Rh(I) + Mo(0), Rh(I) + W(0), Rh(I) + Re(I), Rh(I) + Ru(II), Rh(I) + Os(II), Mo(0) + Mo(0), Mo(0) + W(0), Mo(0) + Re(I), Mo(0) + Ru(II), Mo(0) + Os(II), W(0) + W(0), W(0) + Re(I), W(0) + Ru(II), W(0) + Os(II), Re(I) + Re(I), Re(I) + Ru(II), Re(I) + Os(II), Ru(II) + Ru(II), Ru(II) + Os(II) and Os(II) + Os(II).

4. Organic electroluminescent device according to one or more of Claims 1 to 3, **characterised in that** the coordinating atoms X are equal to phosphorus or equal to arsenic, preferably equal to phosphorus.

5. Organic electroluminescent device according to one or more of Claims 1 to 4, comprising at least one compound of the formula (2), 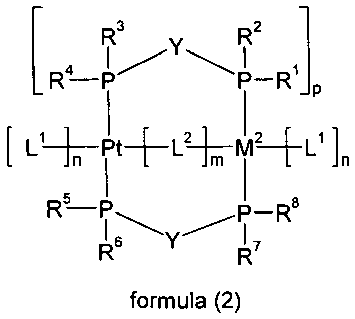 where M², L¹, L², Y, R¹ to R⁸, m, n and p have the meanings mentioned in Claim 1.

6. Organic electroluminescent device according to one or more of Claims 1 to 5, **characterised in that** the radicals R¹ to R⁸ are selected on each occurrence, identically or differently, from the group consisting of F, Si(R⁹)₃, a straight-chain alkyl or alkoxy group having 1 to 10 C atoms or a branched or cyclic alkyl or alkoxy group having 3 to 10 C atoms, each of which may be substituted by one or more radicals R¹⁰, where one or more non-adjacent CH₂ groups which are not bonded directly to X may be replaced by C=O, O, S or CONR¹⁰ and where one or more H atoms may be replaced by D or F, or an alkenyl group having 2 to 10 C atoms, or an aralkyl or heteroaralkyl group having 5 to 20 aromatic ring atoms, which may be substituted by one or more radicals R¹⁰, or an aryloxy or heteroaryloxy group having 5 to 20 aromatic ring atoms, which may be substituted by one or more radicals R¹⁰; R¹ and R², R³ and R⁴, R⁵ and R⁶ and/or R⁷ and R⁸ here may also form a mono- or polycyclic ring system with one another; furthermore, the ligand L¹ may be bonded to one of the groups R¹ to R⁸.

7. Organic electroluminescent device according to one or more of Claims 1 to 6, comprising at least one compound of the formula (3), 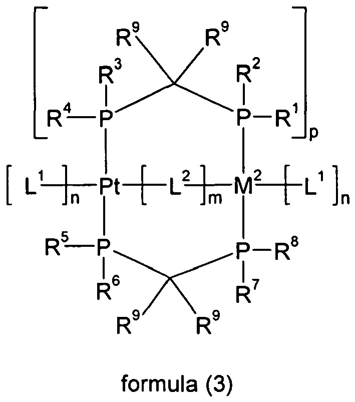 where M², L¹, L², R¹ to R⁹, m, n and p have the meanings mentioned in Claim 1.

8. Organic electroluminescent device according to one or more of Claims 1 to 7, **characterised in that** the ligands L¹ are selected, identically or differently on each occurrence, from carbon monoxide, nitrogen monoxide, isonitriles, amines, phosphines, phosphites, arsines, stibines, nitrogen-containing heterocycles, ethers, aliphatic or aromatic sulfides, aliphatic or aromatic selenides, hydride, deuteride, F, Cl, Br and I, azide, alkylacetylides, aryl- or heteroarylacetylides, alkyl, aryl, heteroaryl, hydroxide, cyanide, cyanate, isocyanate, thiocyanate, isothiocyanate, aliphatic or aromatic alcoholates, aliphatic or aromatic thioalcoholates, amides, carboxylates, anionic, nitrogen-containing heterocycles, aliphatic or aromatic phosphides PR₂⁻, aliphatic or aromatic selenides SeR⁻, O²⁻, S²⁻ , nitrenes, which result in coordination in the form R-N=M, where R generally stands for a substituent, N³⁻, diamines, imines, heterocycles containing two nitrogen atoms, diphosphines, 1,3-diketonates derived from 1,3-diketones, 3-ketonates derived from 3-ketoesters, carboxylates derived from aminocarboxylic acids, salicyliminates derived from salicylimines, dialcoholates derived from dialcohols, dithiolates derived from dithiols and bidentate monoanionic ligands which, with the metal, form a cyclometallated five- or six-membered ring with at least one metal-carbon bond, where these ligands L¹ may also be linked to one of the radicals R¹ to R⁸.

9. Organic electroluminescent device according to one or more of Claims 1 to 8, **characterised in that** the ligands L² are selected, identically or differently on each occurrence, from the group consisting of H, O, S, Se, CO, C=N, NO, alkyl groups, in particular having 1 to 10 C atoms, C(=C(R⁹)₂), -CR⁹=CR⁹-, ortho-phenylene, diphosphides, disulfides, diphosphines, diamines, diamides, carbonate, thiocarbonate, isonitrile, acetylide, thiocarbonyl, and ligands of the formulae (33) to (37): 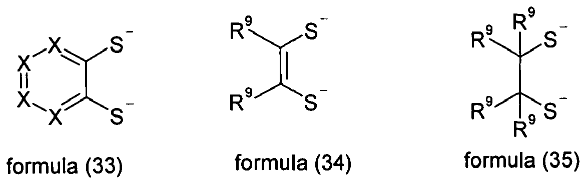 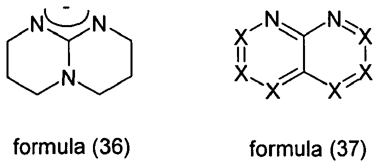 where R⁹ has the meaning mentioned in Claim 1, and X is on each occurrence, identically or differently, CR⁹ or N.

10. Organic electroluminescent device according to one or more of Claims 1 to 9, **characterised in that** the complexes of the formulae (1) to (4) serve as the core of dendrimers or are bonded into polymers.

11. Organic electroluminescent device according to one or more of Claims 1 to 10, **characterised in that** the compound of the formulae (1) to (4) is employed as emission material in an emission layer, where it can either be employed as pure layer or in combination with a matrix material.

12. Organic electroluminescent device according to Claim 11, **characterised in that** the matrix material for the compound of the formula (1) is selected from the group consisting of ketones, phosphine oxides, sulfoxides, sulfones, triarylamines, carbazole derivatives, indolocarbazole derivatives, azacarbazoles, bipolar matrix materials, silanes, azaboroles, boronic esters, triazine derivatives or zinc complexes.

13. Process for the production of an organic electroluminescent device according to one or more of Claims 1 to 12, **characterised in that** one or more layers are applied by means of a sublimation process or **in that** one or more layers are applied by means of the OVPD (organic vapour phase deposition) process or with the aid of carrier-gas sublimation or **in that** one or more layers are produced from solution or by means of any desired printing process.

14. Compound of the formula (38), 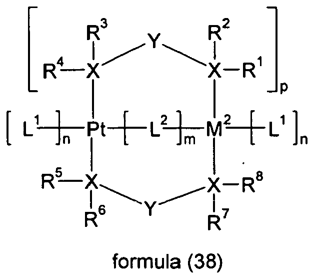 where M², X, Y, R¹ to R⁸, L¹, L², m, n and p have the meanings mentioned in Claim 1;
compounds in which at least one ligand L¹ stands for OH, methyl or phenyl are excluded from the invention;
the following compounds are furthermore excluded from the invention:

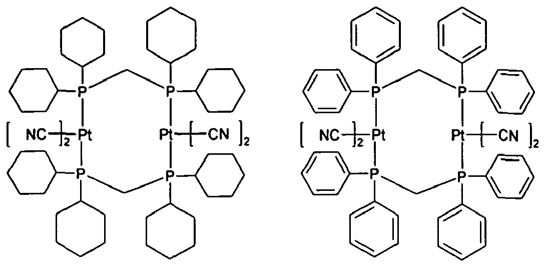

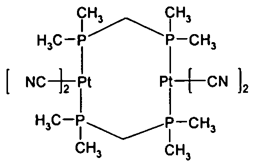

15. Process for the preparation of the compounds according to Claim 14 by reaction of a platinum salt, preferably K₂[PtCl₄] or a similar Pt salt, with a diphosphine to give a complex (diphosphine)PtCl₂, which is then reacted with ligands L¹ or L² to give the compound of the formula (38).

## Revendications

1. Dispositif électroluminescent organique comprenant au moins un composé de la formule (1), 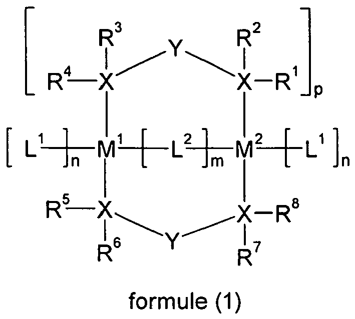 à ce qui suit s'applique aux symboles et indices utilisés :
M¹, M² sont, pour chaque occurrence, de manière identique ou différente, un métal choisi parmi le groupe constitué par Pt, Pd, Ni, Ir, Rh, Mo, W, Re, Ru ou Os ;
X est, pour chaque occurrence, de manière identique ou différente, P, As, Sb ou Bi ;
Y est, pour chaque occurrence, de manière identique ou différente, C(R⁹)₂, Si(R⁹)₂, B(R⁹), N(R⁹), P(R⁹), O, S, Se, C(=O), C(=S), C(=NR⁹) ou C(=C(R⁹)₂) ;
L¹ est, pour chaque occurrence, de manière identique ou différente, un ligand monodenté ou un ligand bidenté, lequel se coordonne sur l'un des atomes métalliques M¹ ou M²; L¹ peut également ici être lié à l'un des groupes R¹ à R⁸;
L² est, pour chaque occurrence, de manière identique ou différente, un ligand bidenté, lequel se coordonne simultanément sur les deux atomes métalliques M¹ et M²;
R¹ à R⁸ sont, pour chaque occurrence, de manière identique ou différente, F, CI, Br, I, N(R¹⁰)₂, CN, Si(R¹⁰)₃, C(=O)R¹⁰, P(R¹⁰)₂, un groupe alkyle, alcoxy ou thioalcoxy en chaîne droite comportant de 1 à 40 atomes de C ou un groupe alkényle ou alkynyle en chaîne droite comportant de 2 à 40 atomes de C ou un groupe alkyle, alkényle, alkynyle, alcoxy ou thioalcoxy ramifié ou cyclique comportant de 3 à 40 atomes de C, dont chacun peut être substitué par un ou plusieurs radicaux R¹⁰, où un ou plusieurs groupes CH₂ non adjacents qui ne sont pas liés directement à X peut/peuvent être remplacés par R¹⁰C=CR¹⁰, C=C, Si(R¹⁰)₂, Ge(R¹⁰)₂, Sn(R¹⁰)₂, C=O, C=S, C=Se, C=NR¹⁰, P(=O)(R¹⁰), SO, SO₂, NR¹⁰, O, S ou CONR¹⁰ et où un ou plusieurs atomes de H peut/peuvent être remplacés par D, F, CI, Br, I, CN ou NO₂, ou un système de cycle aromatique ou hétéroaromatique comportant de 5 à 60 atomes de cycle aromatique, lesquels peuvent dans chaque cas être substitués par un ou plusieurs radicaux R¹⁰, ou un groupe aralkyle ou hétéroaralkyle comportant de 5 à 40 atomes de cycle aromatique , dont chacun peut être substitué par un ou plusieurs radicaux R¹⁰, ou un groupe aryloxy ou hétéroaryloxy comportant de 5 à 40 atomes de cycle aromatique, lesquels peuvent être substitués par un ou plusieurs radicaux R¹⁰, ou un groupe diarylamino, un groupe dihétéroarylamino ou un groupe arylhétéroarylamino comportant de 10 à 40 atomes de cycle aromatique, lesquels peuvent être substitués par un ou plusieurs radicaux R¹⁰; R¹ et R², R³ et R⁴, R⁵ et R⁶ et/ou R⁷ et R⁸ peuvent ici également former un système de cycle monocyclique ou polycyclique, aliphatique, aromatique et/ou benzo-fusionné les uns avec les autres ; en outre, un ou plusieurs radicaux R¹ à R⁸ peut/peuvent être liés à un ou plusieurs ligands L¹ ou L² et par conséquent former un ligand polydenté ;
R⁹ est, pour chaque occurrence, de manière identique ou différente, H, D, F, Cl, Br, I, N(R¹⁰)₂, CN, NO₂, Si(R¹⁰)₃, B(OR¹⁰)₂, C(=O)R¹⁰, P(=O)(R¹⁰)₂, S(=O)R¹⁰, S(=O)₂R¹⁰, OSO₂R¹⁰, un groupe alkyle, alcoxy ou thioalcoxy en chaîne droite comportant de 1 à 40 atomes de C ou un groupe alkényle ou alkynyle en chaîne droite comportant de 2 à 40 atomes de C ou un groupe alkyle, alkényle, alkynyle, alcoxy ou thioalcoxy ramifié ou cyclique comportant de 3 à 40 atomes de C, dont chacun peut être substitué par un ou plusieurs radicaux R¹⁰, où un ou plusieurs groupes CH₂ non adjacents peut/peuvent être remplacé(s) par R¹⁰C=CR¹⁰, C=C, Si(R¹⁰)₂, Ge(R¹⁰)₂, Sn(R¹⁰)₂, C=O, C=S, C=Se, C=NR¹⁰, P(=O)(R¹⁰), SO, SO₂, NR¹⁰, O, S ou CONR¹⁰ et où un ou plusieurs atomes de H peut/peuvent être remplacé(s) par D, F, CI, Br, I, CN ou NO₂, ou un système de cycle aromatique ou hétéroaromatique comportant de 5 à 60 atomes de cycle aromatique, lesquels peuvent dans chaque cas être substitués par un ou plusieurs radicaux R¹⁰, ou un groupe aralkyle ou hétéroaralkyle comportant de 5 à 40 atomes de cycle aromatique, lesquels peuvent dans chaque cas être substitués par un ou plusieurs radicaux R¹⁰, ou un groupe aryloxy ou hétéroaryloxy comportant de 5 à 40 atomes de cycle aromatique, lesquels peuvent être substitués par un ou plusieurs radicaux R¹⁰, ou un groupe diarylamino, dihétéroarylamino ou un groupe arylhétéroarylamino comportant de 10 à 40 atomes de cycle aromatique, lesquels peuvent être substitués par un ou plusieurs radicaux R¹⁰; deux radicaux R⁹ ici qui sont liés au même atome de C ou de Si peuvent également former un système de cycle monocyclique ou polycyclique, aliphatique, aromatique et/ou benzo-fusionné les uns avec les autres ;
R¹⁰ est, pour chaque occurrence, de manière identique ou différente, H, D, F, CI, Br, I, N(R¹¹)₂, CN, NO₂, Si(R¹¹)₃, B(OR¹¹)₂, C(=O)R¹¹, P(=O)(R¹¹)₂, S(=O)R¹¹, S(=O)₂R¹¹, OSO₂R¹¹, un groupe alkyle, alcoxy ou thioalcoxy en chaîne droite comportant de 1 à 20 atomes de C ou un groupe alkényle ou alkynyle en chaîne droite comportant de 2 à 20 atomes de C ou un groupe alkyle, alkényle, alkynyle, alcoxy ou thioalcoxy ramifié ou cyclique comportant de 3 à 20 atomes de C, dont chacun peut être substitué par un ou plusieurs radicaux R¹¹, où un ou plusieurs groupes CH₂ non adjacents peut/peuvent être remplacé(s) par R¹¹C=CR¹¹, CΞC, Si(R11)₂, Ge(R¹¹)₂, Sn(R¹¹)₂, C=O, C=S, C=Se, C=NR¹¹, P(=O)(R¹¹), SO, SO₂, NR¹¹, O, S ou CONR¹¹ et où un ou plusieurs atomes de H peut/peuvent être remplacé(s) par D, F, CI, Br, I, CN ou NO₂, ou un système de cycle aromatique ou hétéroaromatique comportant de 5 à 60 atomes de cycle aromatique, lesquels peuvent dans chaque cas être substitués par un ou plusieurs radicaux R¹¹, ou un groupe aryloxy ou hétéroaryloxy comportant de 5 à 40 atomes de cycle aromatique, lesquels peuvent être substitués par un ou plusieurs radicaux R¹¹, ou un groupe diarylamino, dihétéroarylamino ou un groupe arylhétéroarylamino comportant de 10 à 40 atomes de cycle aromatique, lesquels peuvent être substitués par un ou plusieurs radicaux R¹¹; deux ou plusieurs radicaux adjacents R¹¹ peuvent ici former un système de cycle monocyclique ou polycyclique, aliphatique ou aromatique les uns avec les autres ;
R¹¹ est, pour chaque occurrence, de manière identique ou différente, H, D, F ou un radical ahydrocarbone aliphatique, aromatique et/ou hétéroaromatique comportant de 1 à 20 atomes de C, où, en outre, un ou plusieurs atomes de H peut/peuvent être remplacé(s) par F ; deux substituents R¹¹ ou plus peuvent ici également former un système de cycle monocyclique ou polycyclique, aliphatique ou aromatique les uns avec les autres ;
m, n sont, pour chaque occurrence, de manière identique ou différente, 0, 1, 2 ou 3;
p est 0, 1, 2 ou 3 ;
étant entendu que les indices m, n et p sont sélectionnés de telle sorte que le nombre de coordination sur chacun des métaux M¹ et M² soit de quatre ou cinq.

2. Dispositif électroluminescent organique selon la revendication 1, **caractérisé en ce que** ce qui suit s'applique aux indices m, n et p :
p = 0, n = 0 et m = 3 ; ou
p = 0, n = 1 où L¹ = ligand monodenté et m = 2 ; ou
p = 0, n = 2 où L¹ = ligand monodenté et m = 1 ; ou
p = 0, n = 1 où L¹ = ligand bidenté et m = 1 ; ou
p = 0, n = 3 où L¹ = ligand monodenté et m = 0 ; ou
p = 0, n = 2 où L¹ = ligand monodenté + ligand bidenté et m = 0 ; ou
p 1, n= 0 et m=2 ; ou
p = 1, n = 1 où L¹ = ligand monodenté et m = 1 ; ou
p = 1, n = 2 où L¹ = ligand monodenté et m = 0; ou
p = 1, n = 1 où L¹ = ligand bidenté et m = 0 ; ou
p = 2, n = 1 où L¹ = ligand monodenté et m = 0 ; ou
p = 2, n = 0 et m = 1 ; ou
p = 3, n = 0 et m = 0 ; ou
p = 0, n = 1 où L¹ = ligand monodenté et m = 3 ; ou
p = 0, n = 2 où L¹ = ligand monodenté et m = 2 ; ou
p = 0, n = 1 où L¹ = ligand bidenté et m = 3 ; ou
p = 0, n = 3 où L¹ = ligand monodenté et m = 3 ; ou
p = 0, n = 2 où L¹ = ligand monodenté + ligand bidenté et m = 2 ; ou
p = 0, n = 4 où L¹ = ligand bidenté et m = 0 ; ou
p = 0, n = 2 où L¹ = ligand bidenté et m = 0 ; ou
p = 1, n = 1 où L¹ = ligand monodenté et m = 2 ; ou
p = 1, n = 2 où L¹ = ligand monodenté et m = 1 ; ou p = 1, n = 1 où L¹ = ligand bidenté et m = 1 ; ou
p = 1, n = 3 où L1 = ligand monodenté et m = 0 ; ou
p = 1, n = 2 où L¹ = ligand monodenté + ligand bidenté et m = 0 ; ou
p = 2, n = 1 où L¹ = ligand monodenté et m = 1 ; ou
p = 2, n = 2 où L¹ = ligand monodenté et m = 0 ; ou
p = 2, n = 0 et m = 2.

3. Dispositif électroluminescent organique selon une ou plusieurs des revendications 1 et 2, **caractérisé en ce que** les métaux M¹ et M² sont choisis parmi les combinaisons qui suivent :
Pt(II) + Pt(II), Pt(II) + Pd(II), Pt(II) + Ni(II), Pt(II) + Ir(I), Pt(II) + Rh(I), Pt(II) + Mo(0), Pt(II) + W(0), Pt(II) + Re(I), Pt(II) + Ru(II), Pt(II) + Os(II), Pd(II) + Pd(II), Pd(II) + Ni(II), Pd(II) + Ir(I), Pd(II) + Rh(I), Pd(II) + Mo(0), Pd(II) + W(0), Pd(II) + Re(I), Pd(II) + Ru(II), Pd(II) + Os(II), Ni(II) + Ni(II), Ni(II) + Ir(I), Ni(II) + Rh(I), Ni(II) + Mo(0), Ni(II) + W(0), Ni(II) + Re(I), Ni(II) + Ru(II), Ni(II) + Os(II), Ir(I) + Ir(I), Ir(I) + Rh(I), Ir(I) + Mo(0), Ir(I) + W(0), Ir(I) + Re(I), Ir(I) + Ru(II), Ir(I) + Os(II), Rh(I) + Rh(I), Rh(I) + Mo(0), Rh(I) + W(0), Rh(I) + Re(I), Rh(I) + Ru(II), Rh(I) + Os(II), Mo(0) + Mo(0), Mo(0) + W(0), Mo(0) + Re(I), Mo(0) + Ru(II), Mo(0) + Os(II), W(0) + W(0), W(0) + Re(I), W(0) + Ru(II), W(0) + Os(II), Re(I) + Re(I), Re(I) + Ru(II), Re(I) + Os(II), Ru(II) + Ru(II), Ru(II) + Os(II) et Os(II) + Os(II).

4. Dispositif électroluminescent organique selon une ou plusieurs des revendications 1 à 3, **caractérisé en ce que** les atomes de coordination X sont égaux à phosphore ou égaux à arsenic, de préférence égaux à phosphore.

5. Dispositif électroluminescent organique selon une ou plusieurs des revendications 1 à 4, comprenant au moins un composé de la formule (2), 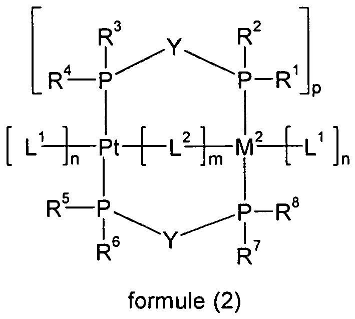 dans laquelle M² , L¹, L², Y, R¹ to R⁸, m, n et p présentent les significations mentionnées selon la revendication 1.

6. Dispositif électroluminescent organique selon une ou plusieurs des revendications 1 à 5, **caractérisé en ce que** les radicaux R¹ à R⁸ sont choisis pour chaque occurrence, de manière identique ou différente, parmi le groupe constitué par F, Si(R⁹)₃, un groupe alkyle ou alcoxy en chaîne droite comportant de 1 à 10 atomes de C ou un groupe alkyle ou alcoxy ramifié ou cyclique comportant de 3 à 10 atomes de C, dont chacun peut être substitué par un ou plusieurs radicaux R¹⁰, où un ou plusieurs groupes CH₂ non adjacents qui ne sont pas liés directement à X peut/peuvent être remplacé(s) par C=O, O, S ou CONR¹⁰ et où un ou plusieurs atomes de H peut/peuvent être remplacé(s) par D ou F, ou un groupe alkényle comportant de 2 à 10 atomes de C, ou un groupe aralkyle ou hétéroaralkyle comportant de 5 à 20 atomes de cycle aromatique, lesquels peuvent être substitués par un ou plusieurs radicaux R¹⁰, ou un groupe aryloxy ou hétéroaryloxy comportant de 5 à 20 atomes de cycle aromatique, lesquels peuvent être substitués par un ou plusieurs radicaux R¹⁰; R¹ et R², R³ et R⁴, R⁵ et R⁶ et/ou R⁷ et R⁸ peuvent ici également former un système de cycle monocyclique ou polycyclique les uns avec les autres ; en outre, le ligand L¹ peut être lié à l'un des groupes R¹ à R⁸.

7. Dispositif électroluminescent organique selon une ou plusieurs des revendications 1 à 6, comprenant au moins un composé de la formule (3), 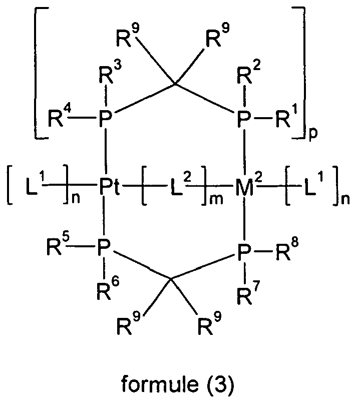 dans laquelle M² , L¹, L², R¹ à R⁹, m, n et p présentent les significations mentionnées selon la revendication 1.

8. Dispositif électroluminescent organique selon une ou plusieurs des revendications 1 à 7, **caractérisé en ce que** les ligands L¹ sont choisis, de manière identique ou différente sur chaque occurrence, parmi monoxyde de carbone, monoxyde d'azote, isonitriles, amines, phosphines, phosphites, arsines, stibines, hétérocycles contenant de l'azote, éthers, sulphures aliphatiques ou aromatiques, sélénures aliphatiques ou aromatiques, hydrures, deutérure, F, Cl, Br et I, azide, alkylacétylides, aryl- ou hétéroarylacétylures, alkyle, aryle, hétéroaryle, hydroxyde, cyanure, cyanate, isocyanate, thiocyanate, isothiocyanate, alcoolates aliphatiques ou aromatiques, thioalcoholates aliphatiques ou aromatiques, amides, carboxylates, hétérocycles anioniques contenant de l'azote, phosphures aliphatiques ou aromatiques PR₂⁻, sélénures aliphatiques ou aromatiques SeR⁻, O²⁻, S²⁻, nitrènes, lesquels aboutissent à une coordination sous la forme R-N=M, où R représente de façon générale un substituent, N³-, des diamines, des imines, des hétérocycles contenant deux atomes d'azote, des diphosphines, des 1,3-dicétonates dérivés de 1,3-dicétones, des 3-cétonates dérivés de 3-cétoesters, des carboxylates dérivés d'acides aminocarboxyliques, des salicyliminates dérivés de salicylimines, des dialcoolates dérivés de dialcools, des dithiolates dérivés de dithiols et des ligands mono-anioniques bidentés qui, avec le métal, forment un cycle cyclométallaté à cinq ou six éléments avec au moins une liaison métal-carbone, où ces ligands L¹ peuvent également être liés à l'un des radicaux R¹ à R⁸.

9. Dispositif électroluminescent organique selon une ou plusieurs des revendications 1 à 8, **caractérisé en ce que** les ligands L² sont choisis, de manière identique ou différente sur chaque occurrence, parmi le groupe constitué par H, O, S, Se, CO, C≡N, NO, des groupes alkyle, en particulier comportant de 1 à 10 atomes de C, C(=C(R⁹)₂), -CR9=CR⁹-, ortho-phénylène, diphosphure, disulphure, diphosphines, diamines, diamides, carbonate, thiocarbonate, isonitrile, acétylide, thiocarbonyle, et des ligands des formules (33) à (37) : 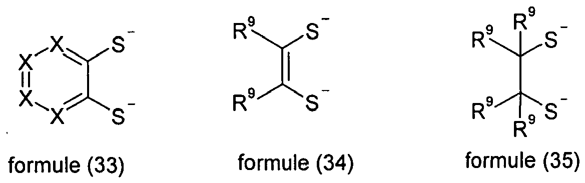 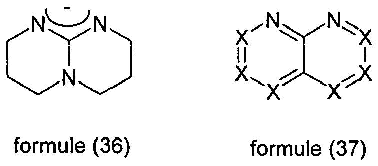 dans lesquelles R⁹ présente la signification mentionnée selon la revendication 1, et X est sur chaque occurrence, de manière identique ou différente, CR⁹ ou N.

10. Dispositif électroluminescent organique selon une ou plusieurs des revendications 1 à 9, **caractérisé en ce que** les complexes des formules (1) à (4) jouent le rôle de noyaux de dendrimers ou sont liés dans des polymères.

11. Dispositif électroluminescent organique selon une ou plusieurs des revendications 1 à 10, **caractérisé en ce que** le composé des formules (1) à (4) est utilisé en tant que matériau d'émission dans une couche d'émission, où il peut soit être utilisé en tant que couche pure, soit en combinaison avec un matériau de matrice.

12. Dispositif électroluminescent organique selon la revendication 11, **caractérisé en ce que** le matériau de matrice pour le composé de la formule (1) est choisi parmi le groupe constitué par des cétones, des oxydes de phosphine, des sulfoxydes, des sulfones, des triarylamines, des dérivés de carbazole, des dérivés d'indolocarbazole, des azacarbazoles, des matériaux de matrice bipolaires, des silanes, des azaboroles, des esters boroniques, des dérivés de triazine ou des complexes de zinc.

13. Procédé pour la fabrication d'un dispositif électroluminescent organique selon une ou plusieurs des revendications 1 à 12, **caractérisé en ce qu'**une ou plusieurs couches sont appliquées au moyen d'un procédé de sublimation ou **en ce qu'**une ou plusieurs couches sont appliquées au moyen du procédé OVPD (dépôt en phase vapeur organique) ou à l'aide d'une sublimation par gaz porteur ou **en ce qu'**une ou plusieurs couches sont produites à partir d'une solution ou au moyen de n'importe quel procédé d'impression souhaité.

14. Composé de la formule (38), 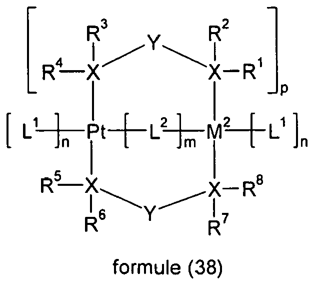 dans laquelle M², X, Y, R¹ to R⁸, L¹, L², m, n et p présentent les significations mentionnées selon la revendication 1 ;
des composés au niveau desquels au moins un ligand L¹ représente OH, méthyle ou pheényle sont exclus de l'invention;
les composés qui suivent sont en outre exclus de l'invention:

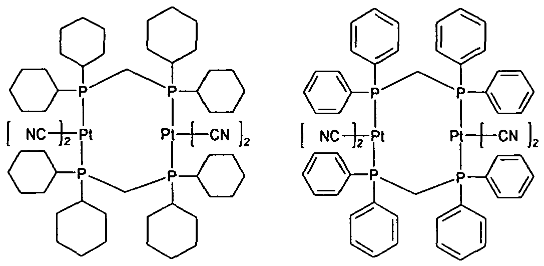

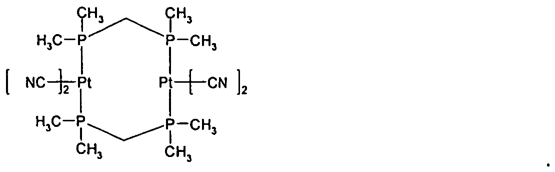

15. Procédé pour la préparation des composés selon la revendication 14 par réaction d'un sel de platine, de préférence K₂[PtCl₄] ou un sel de Pt similaire, avec un diphosphine pour obtenir un complexe (diphosphine)PtCl₂, lequel est ensuite amené à réagir avec des ligands L¹ ou L² pour obtenir le composé de la formule (38).
